# EUROPEAN PATENT APPLICATION

(11) **EP 4 810 253 A1**
(43) Date of publication of application: **23.09.2026**
(21) Application number: 26166277.9
(22) Date of filing: 20.03.2026
(51) Int. Cl.: B32B 38/18, H10K 71/00, G09F 9/30

(54) **APPARATUS AND METHOD FOR MANUFACTURING DISPLAY DEVICE**

(30) Priority: 21.03.2025 KR 20250036623
(71) Applicant: Samsung Display Co., Ltd., Yongin-si, Gyeonggi-do 17113 (KR)
(72) Inventor: Okamoto, Tetsuya, 17113 Yongin-si, Gyeonggi-do (KR); Kang, Minseok, 17113 Yongin-si, Gyeonggi-do (KR); Shin, Hongchul, 17113 Yongin-si, Gyeonggi-do (KR); Woo, Changjo, 17113 Yongin-si, Gyeonggi-do (KR); Lee, Junhee, 17113 Yongin-si, Gyeonggi-do (KR)
(74) Representative: Gulde & Partner

(57) **Abstract**

A method and apparatus for manufacturing a display device are provided. The apparatus for manufacturing a display device includes a first jig (510), a clamping part (700) spaced apart from the first jig (510) and supporting a guide film (GF), a second jig (610) disposed to face the first jig (510) and on which a cover member (CW) having a curved edge is seated, and a sensing part (790) disposed on the clamping part (700) and configured to measure a force applied to the guide film (GF) by the clamping part (700).

## Description

### CROSS-REFERENCE TO RELATED APPLICATION

This application is based on and claims priority to Korean Patent Application No. 10-2025-0036623, filed on March 21, 2025, in the Korean Intellectual Property Office.

### BACKGROUND

### 1. Field

One or more embodiments relate to a method and apparatus for manufacturing a display device.

### 2. Description of the Related Art

Mobile electronic devices are widely used. In addition to small electronic devices such as mobile phones, tablet personal computers (PCs) have been widely used in recent years as mobile electronic devices.

Such mobile electronic devices include display devices to support various functions, for example, providing visual information, such as images or videos, to users. Recently, as other parts for driving display devices have been miniaturized, the proportion occupied by display devices in electronic devices has gradually increased. Also, structures that are bendable from a flat state to a certain angle are under development.

### SUMMARY

As display devices are developed in various forms, defects are occurring frequently during the manufacturing of the display devices. In particular, when an entire edge of a display device is curved, defects may occur when a display panel and a cover member are attached to each other, and the edge of the display panel and the edge of the cover member are separated from each other. One or more embodiments include a method and apparatus for manufacturing a display device, which are capable of precise bonding at a curved portion of a cover member.

Additional aspects will be set forth in part in the description which follows and, in part, will be apparent from the description, or may be learned by practice of the presented embodiments of the disclosure.

According to one or more embodiments, an apparatus for manufacturing a display device includes a first jig having a first working surface, a clamping part spaced apart from the first jig and the clamping part supporting a guide film, a second jig having a second working surface disposed to face the first working surface of the first jig and on the second jig a cover member having a curved edge is seated, and a sensing part disposed on the clamping part and the sensing part is configured to measure a force applied to the guide film by the clamping part.

In an embodiment, the clamping part may include a clamp configured to selectively grip the guide film, a first clamp driving part connected to the clamp and configured to cause the clamp to perform a linear motion, a second clamp driving part connected to the first clamp driving part and configured to adjust a height of the clamp, and a third clamp driving part connected to the second clamp driving part and configured to operate the clamp.

In an embodiment, the apparatus may further include a guide disposed to surround a periphery of the second jig and selectively coming into contact with the guide film.

In an embodiment, a portion of the guide that selectively comes into contact with the guide film may be round.

In an embodiment, the guide may include a guide frame, a first guide roller rotatably disposed on the guide frame, and a second guide roller disposed in a longitudinal direction and a diagonal direction to the first guide roller and rotatably disposed on the guide frame.

In an embodiment, the apparatus may further include a guide driving part configured to connect the guide to the second jig and cause the guide to perform a raising/lowering motion.

In an embodiment, the apparatus may further include a stopper part spaced apart from the first jig and selectively coming into contact with the guide.

In an embodiment, the apparatus may further include a jig driving part connected to at least one of the first jig or the second jig and configured to cause at least one of the first jig or the second jig to perform a linear motion.

In an embodiment, the apparatus may further include a heating part disposed in at least one of the first jig or the second jig.

In an embodiment, the first jig is capable of performing a linear motion, a panel member is disposed on the guide film, the second jig is capable of performing a linear motion to bond the cover member of the second jig to the panel member together with the first jig and the guide is configured to come into contact with the guide film before the cover member comes into contact with the panel member, so that a shape of the panel member is changed.

According to one or more embodiments, an apparatus for manufacturing a display device includes a first jig capable of performing a linear motion and having a first working surface, a clamping part spaced apart from the first jig and the clamping part configured to support a guide film on which a panel member is disposed, a second jig having a second working surface disposed to have the second working surface face the first working surface of first jig and on the second jig a cover member having a curved edge is seated, the second jig being capable of performing a linear motion to bond the cover member to the panel member together with the first jig, and a guide disposed to surround a periphery of the second jig and selectively coming into contact with the guide film, wherein, the guide is configured to come into contact with the guide film before the cover member comes into contact with the panel member, so that a shape of the panel member is changed.

According to one or more embodiments, a method of manufacturing a display device includes disposing a cover member on a second jig, the cover member having an entire edge that is curved, and fixing a guide film to a clamping part, the guide film having a panel member and an adhesive layer disposed thereon, to a clamping part, bringing a guide into contact with the guide film so that the guide film, on which the panel member and the adhesive layer are disposed, is deformed to correspond to one surface of the cover member, adjusting forces applied to at least two parts of the guide film to be equal to a preset force, and bonding the cover member to the adhesive layer by causing at least one of a first jig or the second jig to perform a linear motion.

In an embodiment, the method may further include bringing the guide into contact with a stopper part.

In an embodiment, the method may further include bending a portion of the guide film, a portion of the panel member, and a portion of the adhesive layer by causing the first jig to perform a linear motion.

In an embodiment, the method may further include measuring a force of pulling the guide film at each of the at least two parts of the guide film.

In an embodiment, the method may further include enclosing a space, in which the first jig and the second jig are disposed, with a first chamber and a second chamber.

In an embodiment, the method may further include discharging, to an outside, gas inside a space formed by the first chamber and the second chamber.

In an embodiment, the method may further include aligning a position of the panel member with respect to the cover member.

In an embodiment, the first jig may move together with the panel member.

In an embodiment, a portion of the guide that comes into contact with the guide film may be round.

In an embodiment, the method may further include heating at least one of the first jig or the second jig.

Through the aforementioned embodiments, it is possible to avoid defects in the manufacturing process of a display device, in particular when an edge of the display device is partly or entirely curved. In particular, through the aforementioned embodiments, a separation between a display panel and a cover member at the curved portion of the cover member is avoided or reduced during manufacturing.

Other aspects, features, and advantages of the disclosure will become better understood through the accompanying drawings, the appended claims, and the detailed description.

These general and specific aspects may be practiced by using systems, methods, computer programs, or any combination thereof.

### BRIEF DESCRIPTION OF THE DRAWINGS

The above and other aspects, features, and advantages of certain embodiments of the disclosure will be more apparent from the following description taken in conjunction with the accompanying drawings.
FIG. 1 is a cross-sectional view schematically illustrating an apparatus for manufacturing a display device, according to an embodiment.
FIG. 2 is a perspective view schematically illustrating a portion of a clamping part in the apparatus for manufacturing a display device in FIG. 1.
FIGS. 3A, 3B, and 3C are front views schematically illustrating the clamping parts illustrated in FIG. 1.
FIGS. 4A and 4B are perspective views schematically illustrating a guide illustrated in FIG. 1.
FIG. 5A is a cross-sectional view schematically illustrating the operation of the apparatus for manufacturing a display device in FIG. 1.
FIG. 5B is a front view schematically illustrating a guide film, a display panel, and an adhesive layer illustrated in FIG. 5A.
FIGS. 6A and 6B are plan views schematically illustrating the guide film illustrated in FIG. 5B.
FIG. 7 is a plan view schematically illustrating the display panel and the adhesive layer illustrated in FIG. 5B.
FIG. 8 is a plan view schematically illustrating the positions of the guide film and a cover member illustrated in FIG. 5A.
FIG. 9 is a cross-sectional view schematically illustrating the operation of the apparatus for manufacturing a display device in FIG. 1.
FIG. 10 is a cross-sectional view schematically illustrating the operation of the apparatus for manufacturing a display device in FIG. 1.
FIG. 11A is a cross-sectional view schematically illustrating the operation of the apparatus for manufacturing a display device in FIG. 1.
FIG. 11B is a perspective view schematically illustrating a portion of a guide, a guide film, a display panel, and an adhesive layer illustrated in FIG. 11A.
FIG. 11C is a cross-sectional view schematically illustrating the operation of the apparatus for manufacturing a display device in FIG. 1.
FIGS. 12A, 12B, and 12C are cross-sectional views schematically illustrating the operation of the apparatus for manufacturing a display device in FIG. 1.
FIG. 13 is a cross-sectional view schematically illustrating the operation of the apparatus for manufacturing a display device in FIG. 1.
FIG. 14 is a cross-sectional view schematically illustrating an apparatus for manufacturing a display device, according to an embodiment.
FIG. 15 is a cross-sectional view schematically illustrating an apparatus for manufacturing a display device, according to an embodiment.
FIG. 16 is a cross-sectional view schematically illustrating an apparatus for manufacturing a display device, according to an embodiment.
FIG. 17 is a cross-sectional view schematically illustrating an apparatus for manufacturing a display device, according to an embodiment.
FIG. 18 is an exploded perspective view schematically illustrating a display device according to an embodiment.
FIG. 19 is a perspective view schematically illustrating a display device according to an embodiment.
FIGS. 20A, 20B, and 20C are cross-sectional views schematically illustrating the display device illustrated in FIG. 19.
FIG. 21 is a cross-sectional view schematically illustrating a portion of a display area of a display panel illustrated in FIG. 19.
FIG. 22 is a circuit diagram schematically illustrating a sub-pixel circuit of the display panel illustrated in FIG. 19.
FIG. 23 is a block diagram schematically illustrating an electronic device according to an embodiment.
FIG. 24 is a perspective view schematically illustrating electronic devices according to an embodiment.
FIG. 25 is a perspective view schematically illustrating electronic devices according to an embodiment.
FIG. 26 is a perspective view schematically illustrating electronic devices according to an embodiment.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

As the present description allows for various changes and numerous embodiments, certain embodiments will be illustrated in the drawings and described in detail in the written description. Effects and features of the disclosure, and methods of achieving them will be clarified with reference to embodiments described below in detail with reference to the drawings. However, the disclosure is not limited to the following embodiments and may be embodied in various forms.

Hereinafter, embodiments will be described in detail with reference to the accompanying drawings. When describing embodiments with reference to the accompanying drawings, the same or corresponding elements are denoted by the same reference numerals, and redundant descriptions thereof are omitted.

In the following embodiments, the terms "first," "second," etc. are not used in a restrictive sense and are used to distinguish one element from another.

The singular forms as used herein are intended to include the plural forms as well unless the context clearly indicates otherwise.

It will be further understood that the terms "include" and/or "comprise" as used herein specify the presence of stated features or elements, but do not preclude the presence or addition of one or more other features or elements.

It will be further understood that, when a layer, region, or element is referred to as being "on" another layer, region, or element, it may be directly on the other layer, region, or element, but also intervening layers, regions, or elements may be present therebetween.

Also, sizes of elements in the drawings may be exaggerated or reduced for convenience of explanation. For example, because sizes and thicknesses of elements in the drawings are arbitrarily illustrated for convenience of explanation, the disclosure is not necessarily limited thereto.

The x-axis, the y-axis, and the z-axis are not limited to three axes of the rectangular coordinate system and may be interpreted in a broader sense. For example, the x-axis, the y-axis, and the z-axis may be perpendicular to one another or may represent different directions that are not perpendicular to one another.

When a certain embodiment is implemented differently, a specific process sequence may be performed differently from a sequence described herein. For example, two consecutively described processes may be performed substantially at the same time or performed in an order opposite to the stated order.

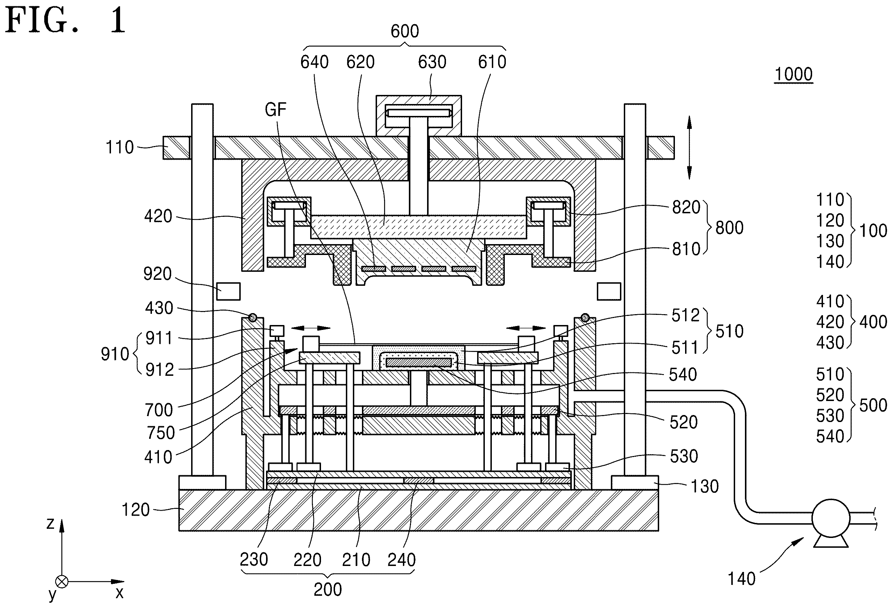

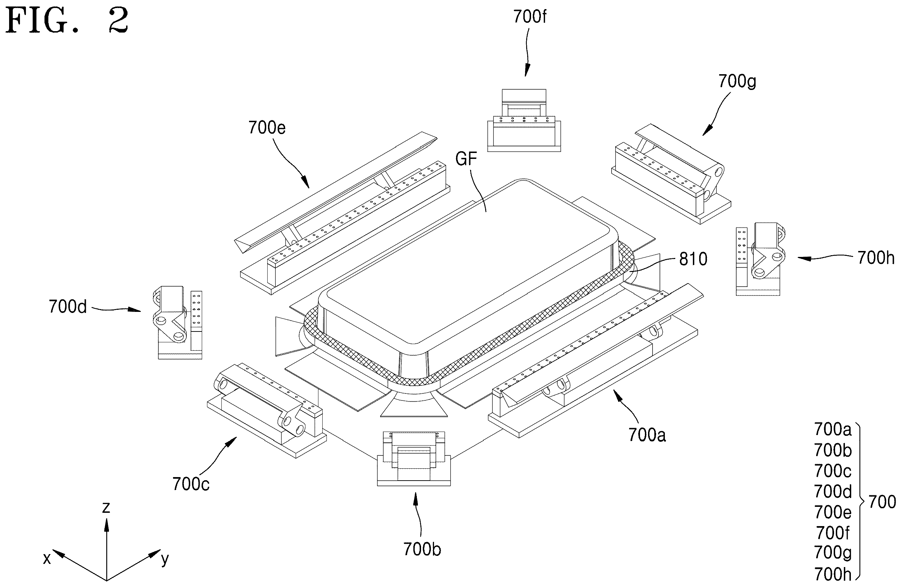

FIG. 1 is a cross-sectional view schematically illustrating an apparatus for manufacturing a display device, according to an embodiment. FIG. 2 is a perspective view schematically illustrating a portion of a clamping part in the apparatus for manufacturing a display device in FIG. 1.

Referring to FIGS. 1 and 2, an apparatus 1000 for manufacturing a display device may include a base part 100, an alignment part 200, a chamber part 400, a first jig part 500, a second jig part 600, a clamping part 700, a guide part 800, a stopper part 910, and a vision part 920.

The base part 100 may include a first support 110, a second support 120, a driving part 130, and a pressure control part 140. The first support 110 may be connected to the driving part 130 and may perform a linear motion according to the operation of the driving part 130. The second support 120 may be fixed to the outside and may support the driving part 130. The driving part 130 may be connected to the first support 110 and the second support 120 and may raise and lower the first support 110. The driving part 130 may have various forms. For example, the driving part 130 may include a pneumatic or hydraulic cylinder. In an embodiment, the driving part 130 may include a motor, a ball screw connected to the motor, and a motion block disposed on the ball screw and performing a linear motion when the ball screw rotates. In an embodiment, the driving part 130 may include a linear motor. However, the driving part 130 is not limited to those described above and may include any structure that connects the first support 110 and the second support 120 to each other and causes the first support 110 to perform a linear motion. The pressure control part 140 may be connected to the chamber part 400 and may control the pressure of the internal space formed by the chamber part 400. The pressure control part 140 may include a pipe connected to the chamber part 400 and a pump disposed in the pipe.

The alignment part 200 may be disposed on the second support 120 and may rotate in at least two directions. The alignment part 200 may include a first alignment stage 210 and a second alignment stage 220 that are spaced apart from each other. In addition, the alignment part 200 may include a first alignment driving part 230 disposed between the first alignment stage 210 and the second alignment stage 220 and having one end connected to one of the first alignment stage 210 and the second alignment stage 220 and the other end connected to the other of the first alignment stage 210 and the second alignment stage 220. At this time, the first alignment driving part 230 may be provided in plurality. The plurality of first alignment driving parts 230 may be disposed at an eccentric portion from the center of one of the first alignment stage 210 and the second alignment stage 220. In an embodiment, when each of the first alignment stage 210 and the second alignment stage 220 has a polygonal shape, each of the first alignment driving parts 230 may be disposed near the vertex of each polygonal shape. In an embodiment, when each of the first alignment stage 210 and the second alignment stage 220 has a circular shape or an elliptical shape, each of the first alignment driving parts 230 may be disposed on the edge portion of each of the first alignment stage 210 and the second alignment stage 220. Depending on the operations of the first alignment driving parts 230, one of the first alignment stage 210 and the second alignment stage 220 may rotate around the other of the first alignment stage 210 and the second alignment stage 220. For convenience of explanation, a case where the second alignment stage 220 rotates around the first alignment stage 210 is mainly described in detail. The alignment part 200 may include a first connection part 240 that connects the first alignment stage 210 to the second alignment stage 220 so that the second alignment stage 220 is rotatable around the first alignment stage 210.

The chamber part 400 may include a first chamber 410, a second chamber 420, and a sealing part 430. The first chamber 410 and the second chamber 420 may be separated from each other. In this case, the first chamber 410 may be fixed to the second support 120, and the second chamber 420 may be fixed to the first support 110. The first chamber 410 and the second chamber 420 may be coupled to each other. When the first chamber 410 and the second chamber 420 are coupled to each other, the first chamber 410 and the second chamber 420 may form a space therein. The sealing part 430 may be disposed in the first chamber 410 or the second chamber 420 and, when the first chamber 410 and the second chamber 420 are coupled to each other, may block ambient air from flowing into the first chamber 410 and the second chamber 420. Although FIG. 1 illustrates that a portion where the first chamber 410 and the second chamber 420 are coupled to each other is flat, the disclosure is not limited thereto. For example, although not illustrated, a portion of the first chamber 410 and a portion of the second chamber 420, where the first chamber 410 and the second chamber 420 are coupled to each other, may include unevenness. In this case, at least one sealing part 430 may be disposed in at least a portion of the unevenness.

The first jig part 500 may include a first jig 510, a first moving plate 520, a first jig driving part 530, and a first heating part 540. The first jig 510 may include a core part 511 and a pad part 512. The core part 511 may include a hard material, such as metal. The pad part 512 may include a flexible and elastic material, such as silicone, rubber, and/or urethane. A major outer surface of the pad part 512 of the first jig 510 may be referred to as a first working surface. The first moving plate 520 may be connected to the first jig 510 and may support the first jig 510. The first moving plate 520 may be connected to the core part 511. The first jig driving part 530 may be disposed in the alignment part 200 and connected to the first moving plate 520. The first jig driving part 530 may raise and lower the first moving plate 520 and the first jig 510. The first jig driving part 530 may have various forms. For example, the first jig driving part 530 may include a cylinder. In an embodiment, the first jig driving part 530 may include a servo motor, a rotatable ball screw connected to the servo motor, and a motion block into which the ball screw is inserted and which performs a linear motion when the ball screw rotates. In this case, the motion block may be disposed on the ball screw and the first moving plate 520. In an embodiment, the first jig driving part 530 may also include a linear motor. However, the first jig driving part 530 is not limited to those described above, and may include any devices and structures that are disposed in the alignment part 200 and cause the first moving plate 520 to perform a linear motion. For convenience of explanation, a case where the first jig driving part 530 includes the servo motor, the ball screw, and the motion block is mainly described in detail. The first heating part 540 may be disposed inside the core part 511. The first heating part 540 may include a heater, and the first heating part 540 may control the surface temperature of the first jig 510 by applying heat to the core part 511. At least one first heating part 540 may be disposed in the core part 511.

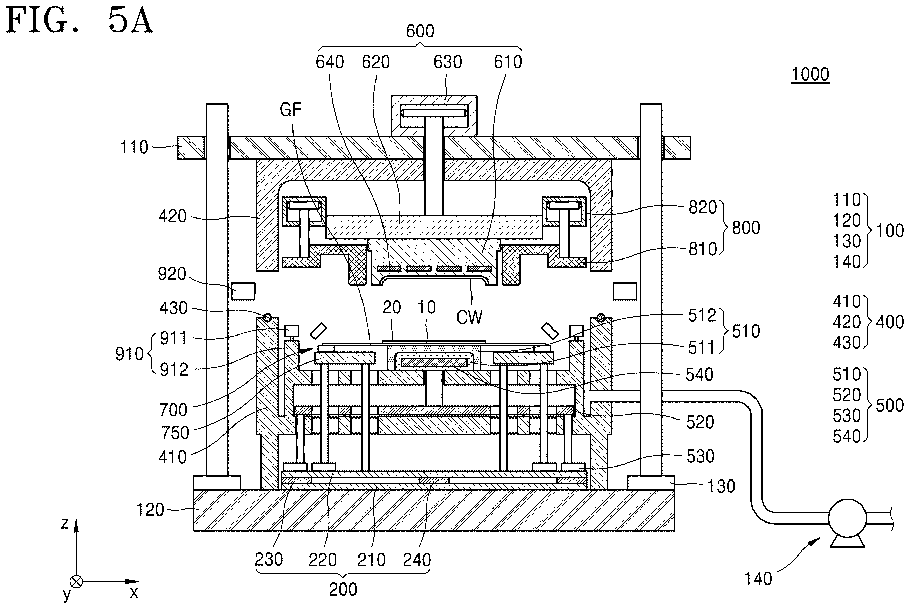

The second jig part 600 may include a second jig 610, a second moving plate 620, a second jig driving part 630, and a second heating part 640. The second jig 610 may include a seating groove in which a cover window CW (see e.g., FIG. 5A), which is a cover member of which the entire edge is curved, is seated. For example, an edge portion of the seating groove may be curved in the Z-direction and wrap completely around the cover member. A major surface of the second jig 610 may be referred to as the second working surface. As shown the second working surface of the second jig 610 may be disposed to face the first working surface of the first jig 510. Although not illustrated, an adhesive layer or a suction hole may be disposed in the seating groove of the second jig 610 so as to fix the cover window CW. In an embodiment, an electrostatic chuck may be disposed in the seating groove of the second jig 610. The second moving plate 620 may be connected to the second jig 610 and may support the second jig 610. The second jig driving part 630 may be connected to the second moving plate 620 and may cause the second moving plate 620 and the second jig 610 to perform a linear motion. In this case, the shape of the second jig driving part 630 may be identical to or similar to the shape of the first jig driving part 530. For convenience of explanation, a case where the second jig driving part 630 is a cylinder is mainly described in detail. At least one second heating part 640 may be disposed inside the second jig 610. When the second heating part 640 is provided in plurality, the plurality of second heating parts 640 may be spaced apart from each other.

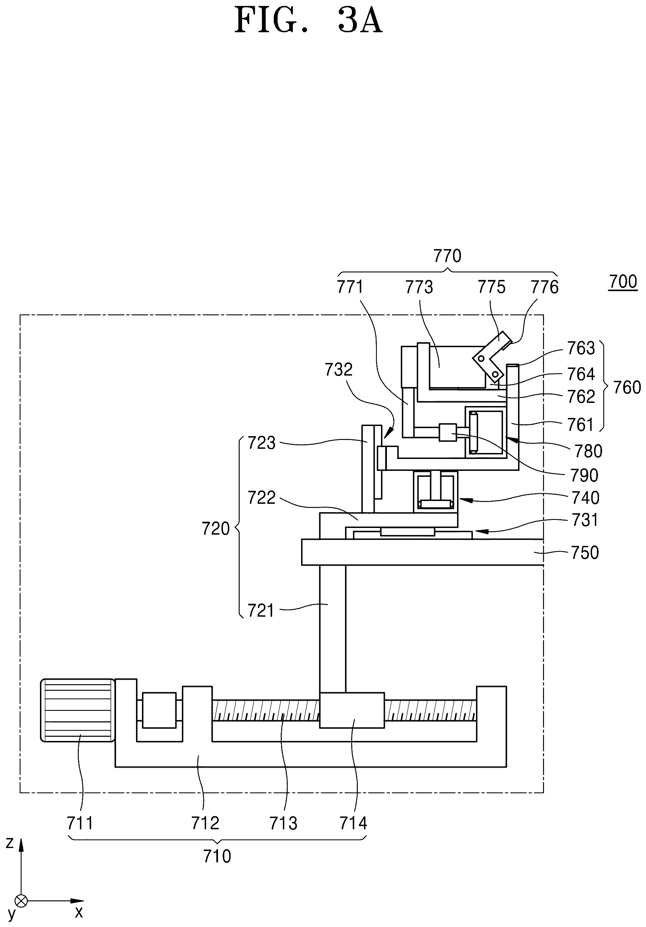

The clamping part 700 may be provided in plurality. Some of the plurality of clamping parts 700 may be seated and fixed to the alignment part 200 so as to be connected to the alignment part 200. The plurality of clamping parts 700 may grip a guide film GF in at least two portions or parts. Hereinafter, a case where the plurality of clamping parts 700 grip the guide film GF at eight portions, as illustrated in FIG. 2, is mainly described in detail. For example, the clamping part 700 may include a first clamping part 700a, a second clamping part 700b, a third clamping part 700c, a fourth clamping part 700d, a fifth clamping part 700e, a sixth clamping part 700f, a seventh clamping part 700g, and an eighth clamping part 700h, which are spaced apart from each other. The first to eighth clamping parts 700a to 700h may be spaced apart from each other. In this case, the second clamping part 700b, the fourth clamping part 700d, the sixth clamping part 700f, and the eighth clamping part 700h may be disposed at corners of the guide part 800 having a rectangular planar shape. The first to eighth clamping parts 700a to 700h may flatten the entire guide film GF by gripping the guide film GF from different directions. In addition, the first to eighth clamping parts 700a to 700h may grip the guide film GF and fix the guide film GF through suction holes disposed at a portion where the first to eighth clamping parts 700a to 700h and the guide film GF come into contact with each other. In some embodiments, the clamping part 700 may be spaced apart from the first jig 510. The structure of the clamping part 700 is described in detail with reference to FIGS. 3A to 3C.

The guide part 800 may include a guide 810 and a guide driving part 820. The guide 810 may have a ring shape. In this case, the second jig 610 may be inserted into the guide 810. Furthermore, the guide 810 may have other planar shapes. For example, the planar shape of the guide 810 may be polygonal. In an embodiment, the guide 810 may have a polygonal shape with round corners. In an embodiment, the planar shape of the guide 810 may be circular or elliptical. However, the planar shape of the guide 810 is not limited to those described above and may be identical to or similar to the shape of a main display area of a display panel described below. The guide driving part 820 may connect the guide 810 and the second moving plate 620 to each other. One end of the guide driving part 820 may be fixed to the second moving plate 620, and the other end of the guide driving part 820 may be fixed to the guide 810. The guide driving part 820 may include a cylinder. When the guide driving part 820 operates, the position of the guide 810 may be changed. For example, the guide 810 may perform a linear motion according to the operation of the guide driving part 820. In some embodiments, the guide driving part 820 may cause the guide 810 to perform a raising and/or lowering motion. In some embodiments, the guide 810 may be disposed to surround a periphery of the second jig 610 and selectively come into contact with the guide film GF.

The stopper part 910 may include a stopper support 912 connected to the first chamber 410 and a stopper 911 disposed on the stopper support 912. In this case, the stopper 911 may be disposed on the stopper support 912 in a height-adjustable form. Accordingly, the final position of the guide 810 may be freely limited. In some embodiments, the stopper part 910 may be spaced apart from the first jig 510 and selectively come into contact with the guide 810.

The vision part 920 may capture an image of the interior of the chamber part 400. In this case, because the vision part 920 is linearly movable in one direction, the vision part 920 may detect the positions of the guide film GF, the display panel 10 (see e.g., FIG. 5A), the first jig 510, and the cover window CW at each stage.

FIG. 3A is a front view schematically illustrating the clamping parts illustrated in FIG. 1.

Referring to FIG. 3A, the clamping part 700 may include a first clamp driving part 710, a first frame 720, a first clamp guide 731, a second clamp guide 732, a second clamp driving part 740, a clamp support 750, a second frame 760, a clamp 770, a third clamp driving part 780, and a sensing part 790. In another embodiment, the clamping part 700 may include a first clamp driving part 710, a first frame 720, a first clamp guide 731, a second clamp guide 732, a second clamp driving part 740, a clamp support 750, a second frame 760, a clamp 770, and a third clamp driving part 780, and the sensing part 790 may be disposed on the clamping part 700. In some embodiments, the first clamp driving part 710 may be connected to the clamp 770 and configured to cause the clamp 770 to perform a linear motion. In some embodiments, the second clamp driving part 740 may be connected to the first clamp driving part 710 and configured to adjust a height of the clamp 770. In some embodiments, the third clamp driving part 780 may be connected to the second clamp driving part 740.

The first clamp driving part 710 may include a first clamp motor 711, a first motor support 712 which is seated on the alignment part 200 and to which the first clamp motor 711 is connected, a first screw 713 rotatably disposed on the first motor support 712 and connected to the first clamp motor 711, and a first motion block 714 which is connected to the first screw 713 so as to be linearly movable and to which the first frame 720 is connected.

The first frame 720 may include a first-1 frame 721 connected to a first motion block 714, a first-2 frame 722 bent from the first-1 frame 721, and a first-3 frame 723 protruding from the first-2 frame 722 and disposed in a similar direction to the first-1 frame 721.

The first clamp guide 731 may be disposed between the first-2 frame 722 and the clamp support 750 and may guide the linear motion of the first-2 frame 722. The first clamp guide 731 may be a linear guide.

The second clamp guide 732 may be disposed between the first-3 frame 723 and the second frame 760. The second clamp guide 732 may guide the linear motion of the second frame 760 when the second frame 760 performs a linear motion. The second clamp guide 732 may be a linear guide.

The second clamp driving part 740 may cause the second frame 760 to perform a linear motion. For example, the second clamp driving part 740 may include a cylinder disposed on the first-2 frame 722 and the second frame 760. The second clamp driving part 740 may be seated on one surface of the first-2 frame 722, and an end of the second clamp driving part 740 may be connected to the second frame 760. When the second clamp driving part 740 operates, the second frame 760 may perform a raising/lowering motion.

The clamp support 750 may connect the clamping part 700 to the alignment part 200. The clamp support 750 may be connected to the alignment part 200 and may form a space therein to provide a movement space for the first jig 510 when the first jig 510 is raised and lowered.

The second frame 760 may include a second-1 frame 761 connected to the second clamp driving part 740 and partially bent, a second-2 frame 762 protruding from the second-1 frame 761, a first cushion part 763 disposed at the end of the second-1 frame 761, and a fixing block 764 disposed at the second-2 frame 762. The first cushion part 763 may include an elastic material, such as rubber or silicone. Furthermore, although not illustrated, a suction hole may be formed in the first cushion part 763. The suction hole may be connected to a path inside the second frame 760. The path may be connected to a pump or the like to provide a passage for movement of gas inside the suction hole.

The clamp 770 may be in the form of a toggle clamp. For example, the clamp 770 may include a connection link 771, a driving force transmission part 773, a rotation part 775, and a second cushion part 776. The connection link 771 may connect the third clamp driving part 780 to the driving force transmission part 773. The driving force transmission part 773 may include at least one link. For example, the driving force transmission part 773 may have a structure in which a plurality of links are connected to each other. At least one of the plurality of links may transmit power by performing a linear motion or a rotational motion. Furthermore, the driving force transmission part 773 may be connected to the rotation part 775 and may rotate the rotation part 775 when the third clamp driving part 780 operates. The rotation part 775 may be partially bent, and the second cushion part 776 may be disposed at the end of the rotation part 775. The second cushion part 776 may be disposed to face the first cushion part 763 by rotating according to the rotation of the rotation part 775 so as to grip the guide film GF or release the grip of the guide film GF. In some embodiments, the clamp 770 may selectively grip the guide film GF.

The third clamp driving part 780 may operate the clamp 770. The third clamp driving part 780 may include a cylinder disposed in the second-1 frame 761. The third clamp driving part 780 may be connected to the connection link 771 and may move the connection link 771. Specifically, when the guide film GF is gripped through the first cushion part 763 and the second cushion part 776, the third clamp driving part 780 may operate. When the third clamp driving part 780 operates, the connection link 771 may rotate the rotation part 775 through the driving force transmission part 773. For example, when the rotation part 775 rotates clockwise in FIG. 3A, the first cushion part 763 and the second cushion part 776 may face each other so that the first cushion part 763 and the second cushion part 776 may grip the guide film GF. A method by which the first cushion part 763 and the second cushion part 776 release the constraint of the guide film GF may be opposite to that described above. That is, when the third clamp driving part 780 operates opposite to that described above, the rotation part 775 may rotate opposite to that described above. In this case, the constraint of the guide film GF may be released as the gap between the first cushion part 763 and the second cushion part 776 increases.

The sensing part 790 may be disposed in at least one of the third clamp driving part 780, the connection link 771, the second frame 760, or the first frame 720. When the clamp 770 pulls the guide film GF due to the operation of the first clamp driving part 710, the sensing part 790 may measure stress (or force) that varies in at least one of the third clamp driving part 780, the connection link 771, the second frame 760, or the first frame 720. In some embodiments, the sensing part 790 may measure a force applied to the guide film GF by the clamping part 700. For example, the sensing part 790 may include a load cell.

Specifically, the first cushion part 763 and the second cushion part 776 may pull the guide film GF so as to maintain the tension of the guide film GF after gripping the guide film GF. The first clamp driving part 710 may operate to move the first frame 720 from the right to the left in FIG. 3A, compared to an initial position. When the first clamp driving part 710 operates to pull the guide film GF after the clamp 770 grips the guide film GF, the second clamp driving part 740 and the third clamp driving part 780 may not operate.

When the first clamp driving part 710 operates, the first clamp driving part 710 may adjust the force for pulling the guide film GF by changing the position of the clamp 770. In this case, a value measured by the sensing part 790 may be changed. It may be determined whether the result measured by the sensing part 790 is equal to a preset value or whether the result measured by the sensing part 790 is within a preset range. The preset value or the preset range may be determined between a minimum tension required to maintain the surface of the guide film GF flat throughout the entire guide film GF and a maximum tension that does not cause the guide film GF to be damaged.

Although not illustrated, the comparison between the result measured by the sensing part 790 and the preset value or the comparison between the result measured by the sensing part 790 and the preset range may be performed by a separate control part (not shown). The control part may be provided in various forms, for example, a circuit board provided in the apparatus for manufacturing a display device, a computer and/or a mobile terminal provided outside the apparatus for manufacturing a display device, etc.

When the control part determines that the value measured by the sensing part 790 is equal to the preset value or is within the preset range, the control part may stop the operation of the first clamp driving part 710 and fix the position of the clamp 770. On the other hand, when the control part determines that the value measured by the sensing part 790 is different from the preset value or is out of the preset range, the control part may control the first clamp driving part 710 to change the position of the clamp 770 so that the value measured by the sensing part 790 is equal to the preset value or is within the preset range.

In this case, the control part may control the positions of the respective clamps 770 so that the forces of the respective clamps 770 for pulling the guide film GF are equal to each other. At this time, the control part may perform control so that the forces of the respective clamps 770 for pulling the guide film GF correspond to the preset value for each process.

Therefore, the method and apparatus for manufacturing a display device may make the tension of the guide film GF equal to the preset tension or within the preset tension range through the above-described processes.

Furthermore, the method and apparatus for manufacturing a display device may precisely determine the tension of the guide film GF by measuring the tension of the guide film GF in real time.

The method and apparatus for manufacturing a display device may provide uniform bonding quality between the panel member and the cover member by keeping the entire surface of the guide film GF flat during the processes.

The method and apparatus for manufacturing a display device may reduce lifting of the panel member from the cover member at the curved portion of the cover member after bonding.

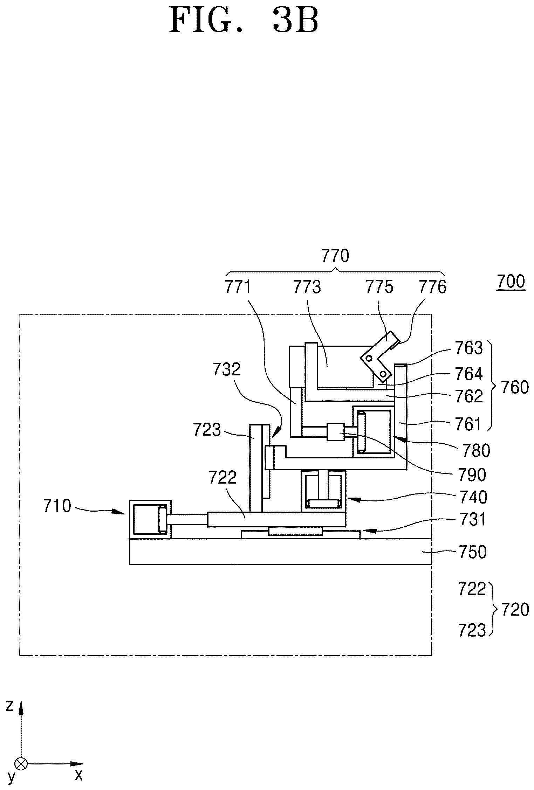

FIG. 3B is a front view schematically illustrating the clamping parts illustrated in FIG. 1.

Referring to FIG. 3B, the clamping part 700 may include a first clamp driving part 710, a first frame 720, a first clamp guide 731, a second clamp guide 732, a second clamp driving part 740, a clamp support 750, a second frame 760, a clamp 770, a third clamp driving part 780, and a sensing part 790. The first frame 720, the first clamp guide 731, the second clamp guide 732, the second clamp driving part 740, the clamp support 750, the second frame 760, the clamp 770, the third clamp driving part 780, and the sensing part 790 may be identical to or similar to the first frame 720, the first clamp guide 731, the second clamp guide 732, the second clamp driving part 740, the clamp support 750, the second frame 760, the clamp 770, the third clamp driving part 780, and the sensing part 790, which have been described with reference to FIG. 3A.

The first clamp driving part 710 may be a cylinder. The first clamp driving part 710 may be seated and fixed to the first moving plate 520. Furthermore, the first frame 720 may perform a linear motion on the first moving plate 520.

The first frame 720 may include a first-2 frame 722 and a first-3 frame 723, and the second frame 760 may include a second-1 frame 761, a second-2 frame 762, a first cushion part 763, and a fixing block 764. Furthermore, the clamp 770 may include a connection link 771, a driving force transmission part 773, a rotation part 775, and a second cushion part 776.

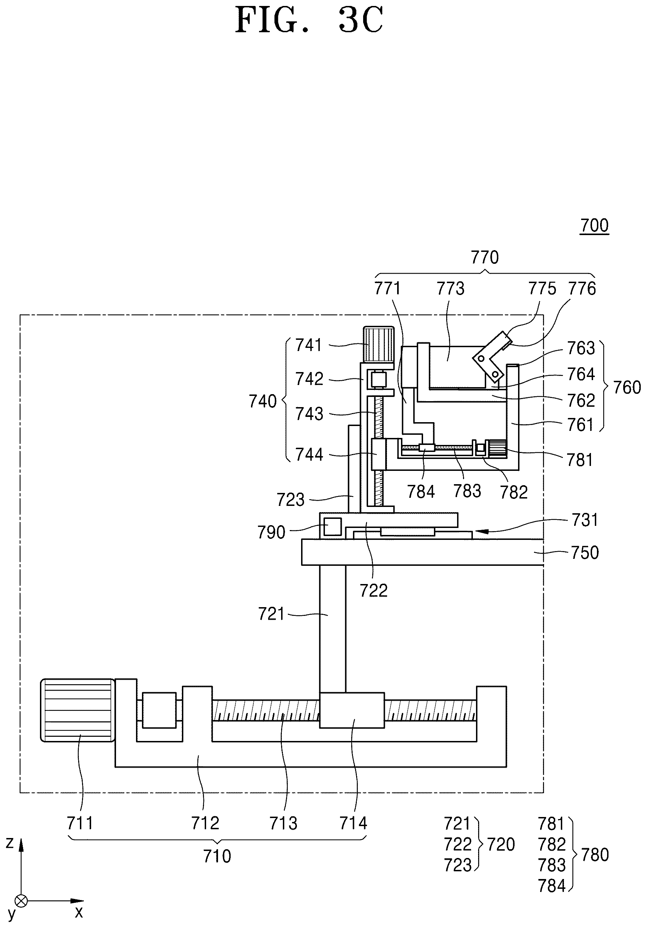

FIG. 3C is a front view schematically illustrating the clamping parts illustrated in FIG. 1.

Referring to FIG. 3C, the clamping part 700 may include a first clamp driving part 710, a first frame 720, a first clamp guide 731, a second clamp driving part 740, a clamp support 750, a second frame 760, a clamp 770, a third clamp driving part 780, and a sensing part 790. The first clamp driving part 710, the first frame 720, the first clamp guide 731, the clamp support 750, the second frame 760, the clamp 770, and the sensing part 790 may be identical to or similar to the first clamp driving part 710, the first frame 720, the first clamp guide 731, the clamp support 750, the second frame 760, the clamp 770, and the sensing part 790, which have been described with reference to FIG. 3A.

The first frame 720 may include a first-1 frame 721, a first-2 frame 722, and a first-3 frame 723, and the second frame 760 may include a second-1 frame 761, a second-2 frame 762, a first cushion part 763, and a fixing block 764. Furthermore, the clamp 770 may include a connection link 771, a driving force transmission part 773, a rotation part 775, and a second cushion part 776.

The second clamp driving part 740 may include a second clamp motor 741, a second motor support 742 which is seated on the first-3 frame 723 and to which the second clamp motor 741 is connected, a second screw 743 rotatably disposed on the second motor support 742 and connected to the second clamp motor 741, and a second motion block 744 which is connected to the second screw 743 so as to be linearly movable and to which the second frame 760 is connected.

The third clamp driving part 780 may include a third clamp motor 781, a third motor support 782 which is seated on the second-1 frame 761 and to which the third clamp motor 781 is connected, a third screw 783 rotatably disposed on the third motor support 782 and connected to the third clamp motor 781, and a third motion block 784 which is connected to the third screw 783 so as to be linearly movable and to which the connection link 771 is connected.

Although not illustrated, each of the first to third clamp driving parts 710 to 780 is not limited to those described above, and may include various devices and structures that move the connected components. For example, each of the first to third clamp driving parts 710 to 780 may have a structure including a cylinder, a linear motor, or a ball screw, a moving block, and a motor.

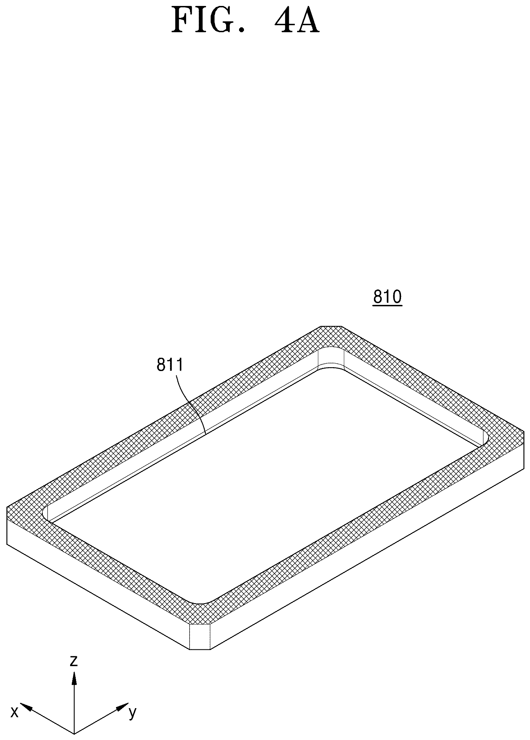

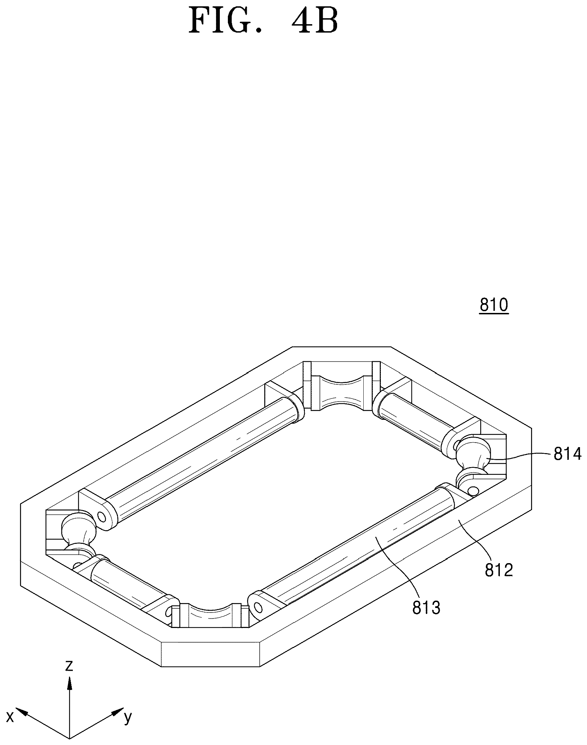

FIGS. 4A and 4B are perspective views schematically illustrating the guide 810 illustrated in FIG. 1.

Referring to FIGS. 4A and 4B, the guide 810 may have various shapes. For example, the guide 810 may have a polygonal ring shape. As illustrated in FIG. 4A, a contact surface 811 of the guide 810 in contact with the guide film may be curved or round. In an embodiment, as illustrated in FIG. 4B, the guide 810 may include a guide frame 812, and a first guide roller 813 and a second guide roller 814 rotatably disposed on the guide frame 812. The first guide roller 813 may have a cylindrical shape, and the second guide roller 814 may have a shape in which the central portion thereof is recessed. The outer surface of the cross-section of the recessed portion of the second guide roller 814 in the longitudinal direction may be curved. In some embodiments, the second guide roller 814 may be disposed in a longitudinal direction and a diagonal direction to the first guide roller 813.

Therefore, the guide 810 may reduce damage to the guide film when coming into contact with the guide film or when applying a force to the guide film after coming into contact with the guide film.

Hereinafter, a method of bonding the panel member (e.g., the display panel 10 in FIG. 5A) to the cover member is described in detail.

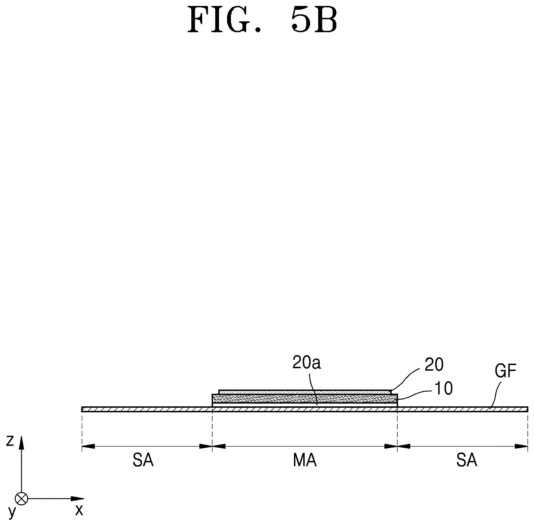

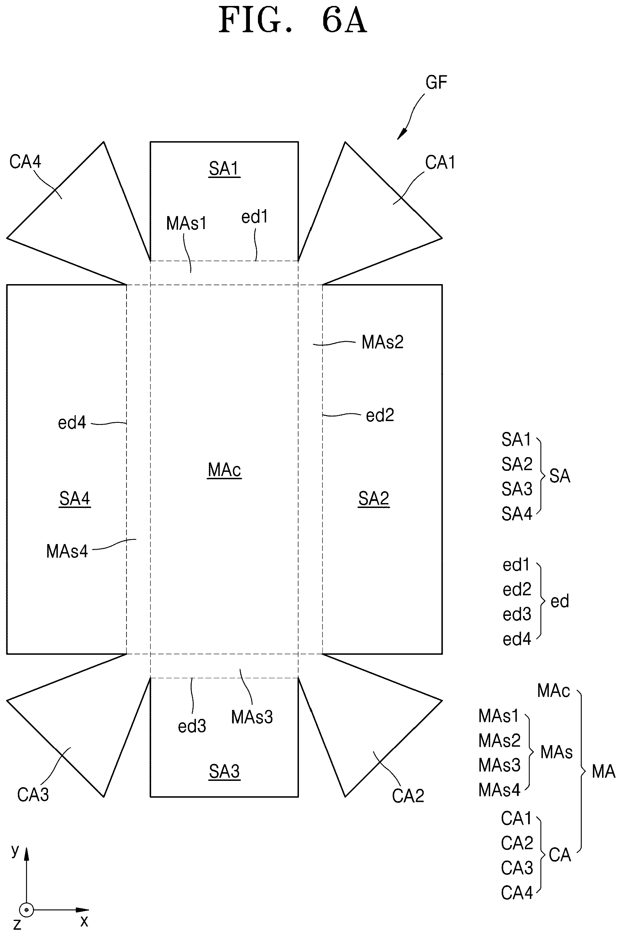

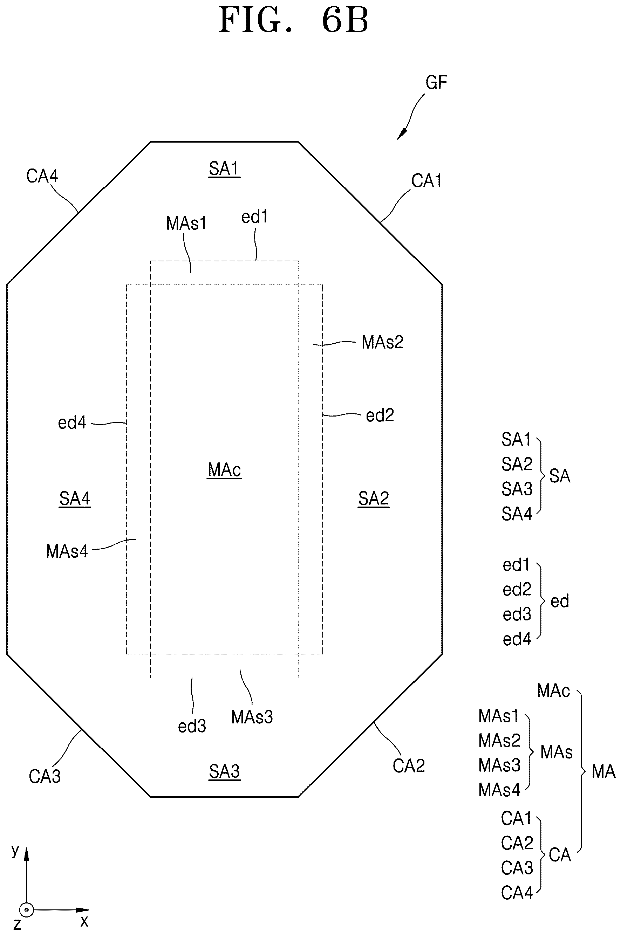

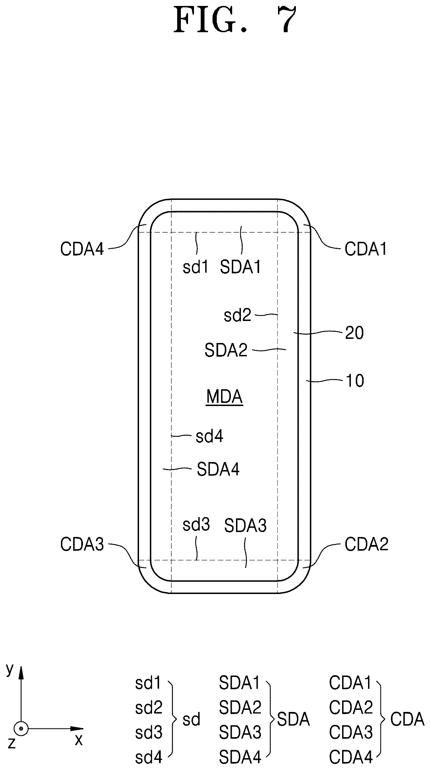

FIG. 5A is a cross-sectional view schematically illustrating the operation of the apparatus for manufacturing a display device in FIG. 1. FIG. 5B is a front view schematically illustrating a guide film, a display panel, and an adhesive layer illustrated in FIG. 5A. FIGS. 6A and 6B are plan views schematically illustrating the guide film illustrated in FIG. 5B. FIG. 7 is a plan view schematically illustrating the display panel and the adhesive layer illustrated in FIG. 5B. Hereinafter, the same reference numerals as those in FIG. 1 denote the members described with reference to FIG. 1.

Referring to FIGS. 5A to 7, the cover window CW may be disposed on the second jig 610, and the display panel 10 may be disposed on the guide film GF on which a first adhesive layer 20 is disposed.

Referring to FIG. 6A, the guide film GF may include a main area MA and a sub-area SA.

The sub-area SA may be connected to an edge ed of the main area MA. The sub-area SA may extend from the edge ed of the main area MA.

The sub-area SA may be provided in plurality. For example, the sub-area SA may include a first sub-area SA1 connected to a first edge ed1 of the main area MA, a second sub-area SA2 connected to a second edge ed2 of the main area MA, a third sub-area SA3 connected to a third edge ed3 of the main area MA, and a fourth sub-area SA4 connected to a fourth edge ed4 of the main area MA. As illustrated in FIG. 6A, the second edge ed2 may cross the first edge ed1, the third edge ed3 may be parallel to the first edge ed1, and the fourth edge ed4 may be parallel to the second edge ed2.

The plurality of sub-areas SA may be spaced apart from each other. The first sub-area SA1 may be spaced apart from the second sub-area SA2, the third sub-area SA3, and the fourth sub-area SA4. The second sub-area SA2 may be spaced apart from the first sub-area SA1, the third sub-area SA3, and the fourth sub-area SA4. The third sub-area SA3 may be spaced apart from the first sub-area SA1, the second sub-area SA2, and the fourth sub-area SA4. The fourth sub-area SA4 may be spaced apart from the first sub-area SA1, the second sub-area SA2, and the third sub-area SA3.

The main area MA may include a central area MAc, side areas MAs, and corner areas CA.

The central area MAc corresponds to the center of the main area MA. As illustrated in FIG. 6A, the central area MAc may have a rectangular shape when viewed from a direction (e.g., a z direction) perpendicular to the main area MA.

The side areas MAs may be disposed between the central area MAc and the sub-area SA. The side area MAs may be provided in plurality. The plurality of side areas MAs may be respectively disposed between the central area MAc and the plurality of sub-areas SA.

For example, the side areas MAs may include a first side area MAs1, a second side area MAs2, a third side area MAs3, and a fourth side area MAs4. The first side area MAs1, the second side area MAs2, the third side area MAs3, and the fourth side area MAs4 may be respectively disposed between the central area MAc and the plurality of sub-areas SA. The first side area MAs1 may be disposed between the central area MAc and the first sub-area SA1, the second side area MAs2 may be disposed between the central area MAc and the second sub-area SA2, the third side area MAs3 may be disposed between the central area MAc and the third sub-area SA3, and the fourth side area MAs4 may be disposed between the central area MAc and the fourth sub-area SA4.

The corner area CA may be disposed at the corner of the main area MA. The display panel 10 may be attached to correspond to the main area MA of the guide film GF. In this case, the corner area CA of the main area MA may correspond to a corner display area CDA of the display panel 10.

The corner area CA may be provided in plurality. The plurality of corner areas CA may be disposed at the corners of the main area MA. Furthermore, the corner area CA may connect the side areas MAs to each other. For example, the corner area CA may include a first corner area CA1, a second corner area CA2, a third corner area CA3, and a fourth corner area CA4. The first corner area CA1, the second corner area CA2, the third corner area CA3, and the fourth corner area CA4 may be respectively at the corners of the main area MA. The first corner area CA1 may connect the first side area MAs1 to the second side area MAs2, the second corner area CA2 may connect the second side area MAs2 to the third side area MAs3, the third corner area CA3 may connect the third side area MAs3 to the fourth side area MAs4, and the fourth corner area CA4 may connect the first side area MAs1 to the fourth side area MAs4.

The corner area CA may protrude between the sub-areas SA spaced apart from each other. For example, the first corner area CA1 may protrude between the first sub-area SA1 and the second sub-area SA2, the second corner area CA2 may protrude between the second sub-area SA2 and the third sub-area SA3, the third corner area CA3 may protrude between the third sub-area SA3 and the fourth sub-area SA4, and the fourth corner area CA4 may protrude between the first sub-area SA1 and the fourth sub-area SA4. The corner area CA may protrude to a length similar to the length of the sub-area SA. That is, the degree to which the corner area CA protrudes away from the center of the guide film GF may vary. The corner area CA may have an inverted triangular shape. That is, the width of the planar shape of the corner area CA may increase as the distance from the central area MAc increases.

Referring to FIG. 6B, the first corner area CA1, the second corner area CA2, the third corner area CA3, and the fourth corner area CA4 may each be disposed between the adjacent sub-areas so that the adjacent sub-areas are connected to each other. The guide film GF may have an octagonal shape.

The planar shape of the guide film GF is not illustrated, but the disclosure is not limited thereto. For example, the planar shape of the guide film GF may be circular or elliptical. In an embodiment, the guide film GF may have other polygonal shapes other than the octagonal shape illustrated in FIG. 6B. In an embodiment, the guide film GF may include only the central area MAc, the side areas MAs, and the sub-areas SA illustrated in FIG. 6A. In an embodiment, the guide film GF may include the central area MAc, the side areas MAs, the sub-areas SA, and the corner areas CA illustrated in FIG. 6A. In this case, the planar shape of the corner area CA may have a fan shape that connects the adjacent sub-areas SA to each other.

Referring to FIG. 7, the display panel 10 disposed on the guide film GF may include a main display area MDA, a sub-display area SDA, and a corner display area CDA, in which a plurality of pixels are spaced apart from each other. Although not illustrated in FIG. 7, the display panel 10 may further include a peripheral area outside the main display area MDA, the sub-display area SDA, and the corner display area CDA. No pixels are disposed in the peripheral area.

The sub-display area SDA may be connected to a side sd of the main display area MDA. The sub-display area SDA may extend from the side sd of the main display area MDA.

The sub-display area SDA may be provided in plurality. For example, the sub-display area SDA may include a first sub-display area SDA1 connected to a first side sd1 of the main display area MDA, a second sub-display area SDA2 connected to a second side sd2 of the main display area MDA, a third sub-display area SDA3 connected to a third side sd3 of the main display area MDA, and a fourth sub-display area SDA4 connected to a fourth side sd4 of the main display area MDA.

The corner display area CDA may be connected to the corner of the main display area MDA. The corner display area CDA may extend from the corner of the main display area MDA. The corner display area CDA may be disposed between the plurality of sub-display areas SDA.

For example, the corner display area CDA may include a first corner display area CDA1, a second corner display area CDA2, a third corner display area CDA3, and a fourth corner display area CDA4. The first corner display area CDA1, the second corner display area CDA2, the third corner display area CDA3, and the fourth corner display area CDA4 may be respectively connected to the corners of the main display area MDA. The first corner display area CDA1 may be disposed between the first sub-display area SDA1 and the second sub-display area SDA2, the second corner display area CDA2 may be disposed between the second sub-display area SDA2 and the third sub-display area SDA3, the third corner display area CDA3 may be disposed between the third sub-display area SDA3 and the fourth sub-display area SDA4, and the fourth corner display area CDA4 may be disposed between the first sub-display area SDA1 and the fourth sub-display area SDA4.

Referring to FIG. 5B, a second adhesive layer 20a may be disposed between the back surface of the display panel 10 and the guide film GF, and the back surface of the display panel 10 may be attached to the guide film GF through the second adhesive layer 20a. The second adhesive layer 20a may be a transparent adhesive member, such as an optically clear adhesive (OCA) film. The second adhesive layer 20a may include a silicone-based OCA film.

The guide film GF may be attached to the back surface of the display panel 10 so that the back surface of the display panel 10 corresponds to the main area MA of the guide film GF. The main display area MDA, the sub-display area SDA, and the corner display area CDA of the display panel 10 may be attached to correspond to the main area MA of the guide film GF. The sub-area SA of the guide film GF and the display panel 10 may not overlap each other.

Referring to FIG. 5A, the guide film GF may be fixed by the clamping part 700, and the cover window CW may be seated and fixed to the second jig 610. A portion of the guide film GF may be in contact with the first jig 510. By sucking gas inside the suction holes formed in the first jig 510 and the second jig 610, the first jig 510 may fix the guide film GF and the second jig 610 may fix the cover window CW.

When the guide film GF is fixed to the clamping part 700 and the first jig 510, and the cover window CW is fixed to the second jig 610, the first heating part 540 and the second heating part 640 may operate to heat the guide film GF and the cover window CW respectively. At this time, the first heating part 540 and the second heating part 640 may heat the first jig 510 and the second jig 610, respectively, to indirectly increase the temperatures of the display panel 10 and the first adhesive layer 20 on the guide film GF and the temperature of the cover window CW. In this case, the first heating part 540 and the second heating part 640 may be controlled so that the temperature of the first jig 510 is higher than the temperature of the second jig 610.

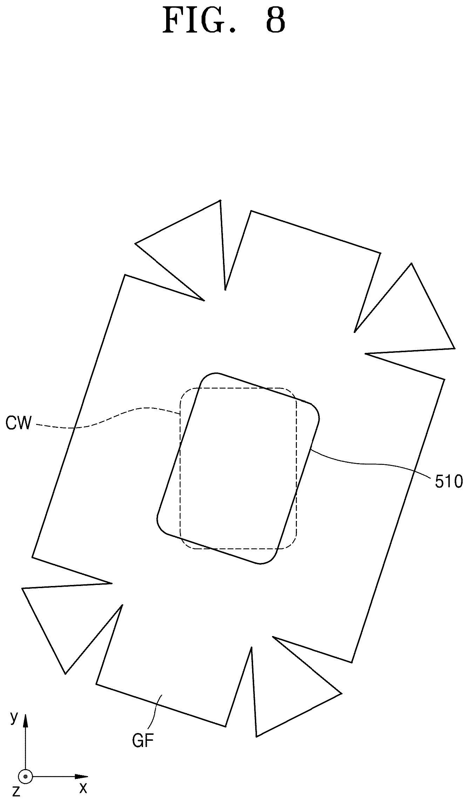

FIG. 8 is a plan view schematically illustrating the positions of the guide film and the cover member illustrated in FIG. 5A.

Referring to FIG. 8 and FIG. 5A, the first jig 510 and the cover window CW may be aligned to correspond to each other.

Specifically, the vision part 920 may capture images of the cover window CW and the first jig 510 and transmit the captured images to the control part. The control part may determine whether the positions of the cover window CW and the first jig 510 correspond each other, based on the positions of the cover window CW and the first jig 510, of which images are captured.

When the control part determines that the cover window CW and the first jig 510 are misaligned with each other, the control part may rotate the first jig 510 and the guide film GF so that the position of the first jig 510 corresponds to the position of the cover window CW. In some embodiments, the first jig 510 may move together with the display panel 10.

Specifically, the vision part 920 may capture images of the first jig 510, the guide film GF, and/or the display panel 10. Furthermore, the vision part 920 may capture images of the cover window CW and/or the second jig 610. In this case, the control part may determine whether the positions of the first jig 510, the guide film GF, and/or the display panel 10 correspond to the positions of the cover window CW and/or the second jig 610, based on a result captured by the vision part 920. For example, the control part may compare a portion of the edge of the first jig 510, a portion of the edge of the guide film GF, and/or a portion of the edge of the display panel 10, or an alignment mark separately provided on the guide film GF and/or the display panel 10 in the images captured by the vision part 920, with an alignment mark separately provided on the cover window CW, or at least a portion of the edge of the cover window CW, and/or at least a portion of the edge of the second jig 610. When the control part determines that a portion of the edge of the first jig 510, a portion of the edge of the guide film GF, and/or a portion of the edge of the display panel 10, or the alignment mark separately provided on the guide film GF and/or the display panel 10 in the images captured by the vision part 920 are different from the alignment mark separately provided on the cover window CW, at least a portion of the edge of the cover window CW, and/or at least a portion of the edge of the second jig 610, the control part may align the positions of the first jig 510, the guide film GF, and the display panel 10 so that a portion of the edge of the first jig 510, a portion of the edge of the guide film GF, and/or a portion of the edge of the display panel 10, or the alignment mark separately provided on the guide film GF and/or the display panel 10 in the images captured by the vision part 920 match the alignment mark separately provided on the cover window CW, or at least a portion of the edge of the cover window CW, and/or at least a portion of the edge of the second jig 610. Specifically, the control part may operate the first alignment driving part 230 to rotate the second alignment stage 220 around the first alignment stage 210. In this case, the clamping part 700 may rotate so that the guide film GF and the display panel 10 rotate and the first jig 510 rotates. At this time, because the clamping part 700 and the first jig 510 move simultaneously and identically, the positions of the guide film GF, the display panel 10, and the first jig 510 may not be misaligned with each other. The vision part 920 may capture images of the first jig 510, the guide film GF, the display panel 10, the cover window CW, and the second jig 610 while the above-described process is in progress, and the control part may continue to perform the above-described operation based on the result captured by the vision part 920.

When it is determined that the first jig 510 and the second jig 610 are disposed to correspond to each other or that the cover window CW and the display panel 10 are disposed to correspond to each other, the display panel 10 and the cover window CW may be bonded to each other.

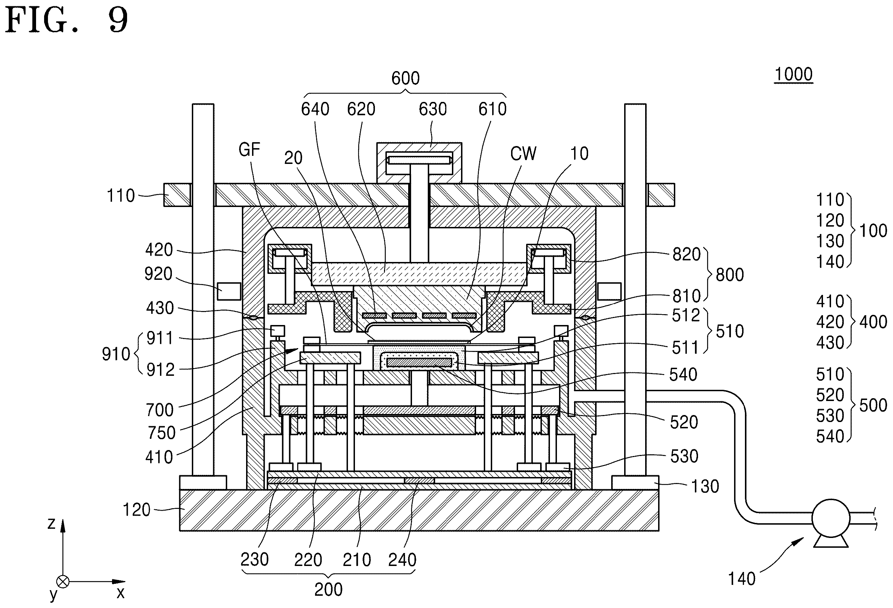

FIG. 9 is a cross-sectional view schematically illustrating the operation of the apparatus for manufacturing a display device in FIG. 1. In FIG. 9, the same reference numerals as those in FIG. 1 denote the same members.

Referring to FIG. 9, the driving part 130 may operate to lower the first support 110. When the first support 110 is lowered, the second jig part 600, the second chamber 420, and the guide part 800 may be lowered simultaneously.

Due to the lowering of the first support 110, the second chamber 420 and the first chamber 410 may come into contact with each other to form a single space. In this case, the sealing part 430 may prevent gas from flowing into the space between the first chamber 410 and the second chamber 420.

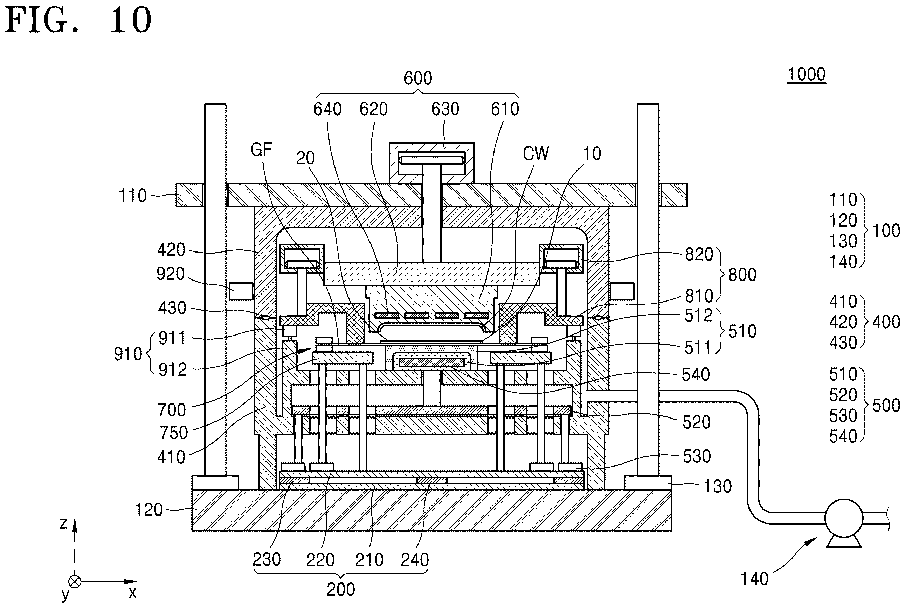

FIG. 10 is a cross-sectional view schematically illustrating the operation of the apparatus for manufacturing a display device in FIG. 1. In FIG. 10, the same reference numerals as those in FIG. 1 denote the same members.

Referring to FIG. 10, after the first chamber 410, the second chamber 420, and the sealing part 430 form a sealed space, the guide driving part 820 may operate to lower the guide 810. At this time, the lower end of the guide 810 may protrude from the lower end of the second jig 610.

Furthermore, at least a portion of the guide 810 may come into contact with the stopper part 910. In this case, the guide 810 may be no longer lowered and the position of the guide 810 may be fixed. In this case, a portion where the guide 810 and the stopper part 910 come into contact with each other may be identical to or similar to a portion where the display panel 10 and the cover window CW are bonded to each other.

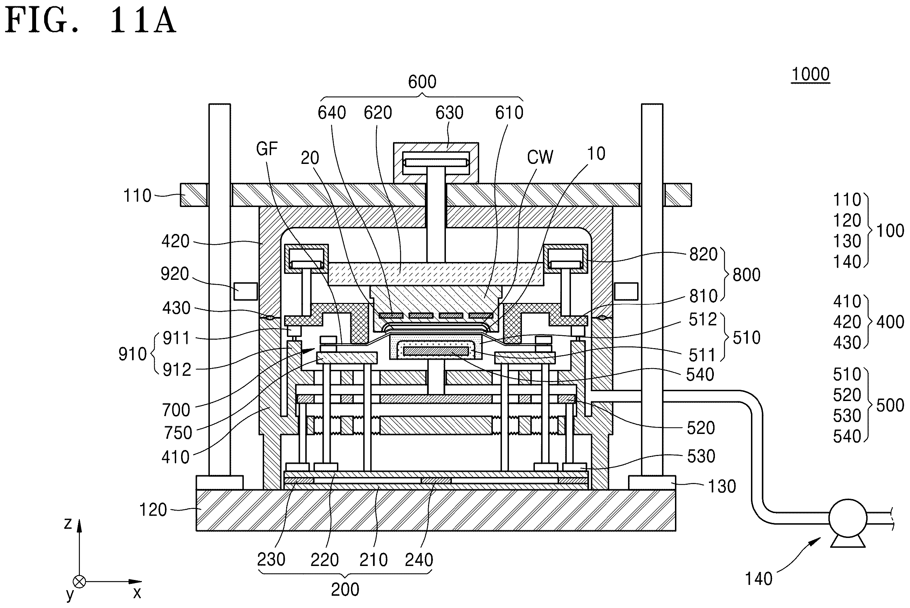

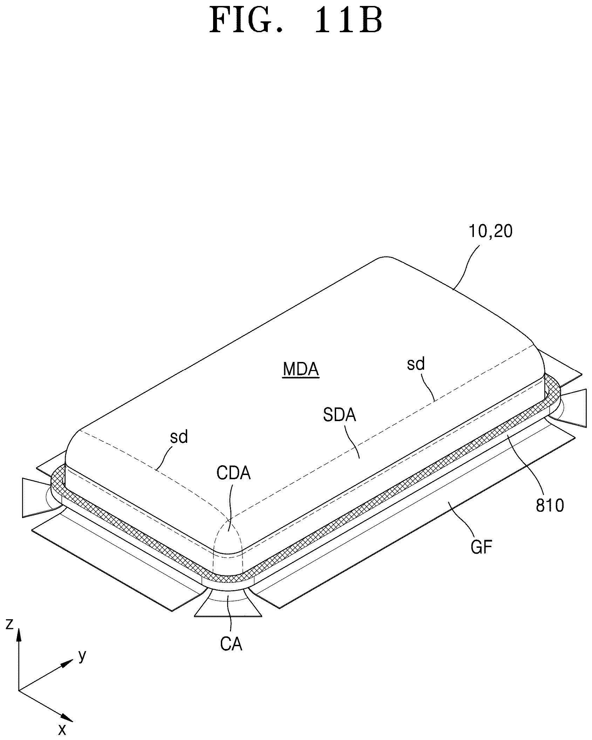

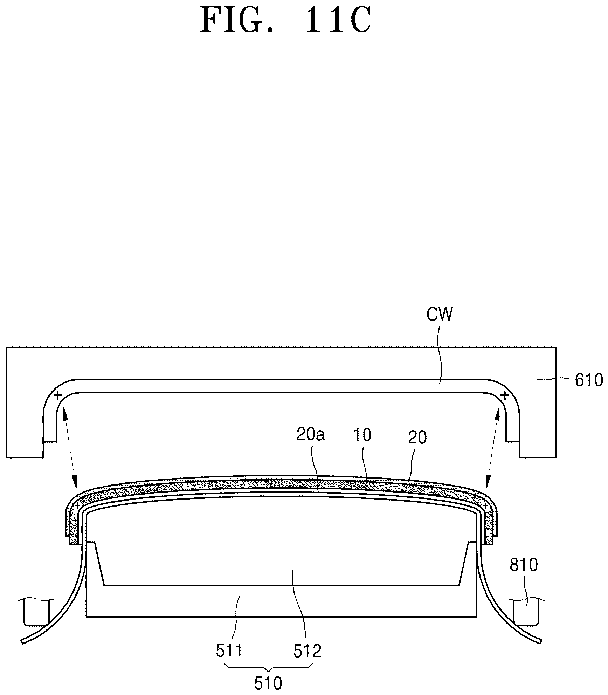

FIG. 11A is a cross-sectional view schematically illustrating the operation of the apparatus for manufacturing a display device in FIG. 1. FIG. 11B is a perspective view schematically illustrating a portion of the guide, the guide film, the display panel, and the adhesive layer illustrated in FIG. 11A. FIG. 11C is a cross-sectional view schematically illustrating the operation of the apparatus for manufacturing a display device in FIG. 1. In FIGS. 11A to 11C, the same reference numerals as those in FIG. 1 denote the same members.

Referring to FIGS. 11A to 11C, the first jig driving part 530 may operate to raise the first moving plate 520 and the first jig 510. As the first jig 510 is raised, the guide film GF, on which the display panel 10 is disposed, may be raised. In this case, the position of the end of the guide film GF constrained by the clamping part 700 may not change.

A portion of the guide film GF may be raised together with the first jig 510 and come into contact with the guide 810. At this time, the guide 810 may bend the guide film GF, and a portion of the guide film GF may come into close contact with the side surface of the first jig 510.

In this case, the shapes of the display panel 10 and the first adhesive layer 20 disposed on the guide film GF may change together with the guide film GF to correspond to one surface of the cover window CW. For example, the edge portion of the display panel 10 and the edge portion of the first adhesive layer 20 may be bent. The guide 810 may improve the bonding quality of the display panel 10 and the cover window CW by changing the shape of the guide film GF to the shape of the cover window CW before the cover window CW and the display panel 10 are bonded to each other. Specifically, when the display panel 10 and the cover window CW are bonded together without previously deforming the display panel 10, the display panel 10 and the cover window CW may be separated from each other at the curved edge portion of the cover window CW after the display panel 10 and the cover window CW are bonded together due to the self-restoring force of the display panel 10. However, at least a portion of the display panel 10 may be previously deformed by deforming the guide film GF into the guide 810, so that a portion of the restoring force of the display panel 10 is reduced. Accordingly, after the display panel 10 and the cover window CW are bonded to each other, the separation of the display panel 10 from the cover window CW at the curved portion of the cover window CW may be reduced.

In this case, the guide 810 may be disposed to surround the periphery of the first jig 510. At this time, the first jig 510 may be disposed to be inserted into the guide 810.

Specifically, the guide film GF may be brought into close contact with the side surface of the first jig 510 by using the guide 810. The guide 810 may be disposed in the sub-area SA of the guide film GF and the corner area CA of the guide film GF. As a result, the display panel 10 may be preformed into a shape that matches the cover window CW.

An external force may be applied to the guide film GF seated on the first jig 510 through the guide 810. That is, an external force may be applied to the sub-area SA of the guide film GF through the guide 810, and an external force may be applied to the corner area CA of the guide film GF through the guide 810.

The guide film GF may be bent by the external force applied to the guide film GF. For example, the main area MA of the guide film GF may be deformed to have a curvature. When the guide film GF is deformed by the external force, the shape of the display panel 10 attached to the main area MA of the guide film GF may also be deformed. For example, as illustrated in FIG. 11B, the sub-display area SDA and the corner display area CDA of the display panel 10 may be deformed to have a curvature. In particular, the corner display area CDA may contract as the sub-display areas SDA adjacent to the corner display area CDA are bent. The preformed display panel 10 may be divided into an area including a curvature and an area not including a curvature with respect to each side sd of the main display area MDA.

As a result of preforming the display panel 10, the sub-display area SDA and the corner display area CDA of the display panel 10 may be disposed on the same side with respect to the main display area MDA. For example, as illustrated in FIG. 11B, the sub-display area SDA and the corner display area CDA of the display panel 10 may be disposed on the back side (e.g., in a -z direction) of the display panel 10 with respect to the main display area MDA.

In an embodiment, the guide film GF may include the corner area CA. As described above, when forming the corner display area CDA of the display panel 10, the corner display area CDA may receive a contracting force from the sub-display areas SDA adjacent to the corner display area CDA. The corner display area CDA may be pressed. The guide film GF according to an embodiment may be freely deformed by the external force applied to the guide film GF. For example, when a contracting force is applied to the guide film GF, the guide film GF may be deformed without wrinkles or the like occurring on the surface of the guide film GF.

Referring to FIG. 11C, the shape of the first jig 510 may have a central portion that protrudes more than other portions. In this case, the upper surface of the first jig 510 may protrude more toward the cover window CW in the main display area MDA of the display panel 10 than in the other display areas.

While the above-described process is in progress, the sensing part 790 may detect a force that pulls the guide film GF at each clamping part 700. In some embodiments, a force of pulling the guide film GF may be measured at each of at least two parts of the guide film GF. The control part may control the first clamp driving part of the clamping part 700 so that the result measured by the sensing part 790 corresponds to a set force required to pull each portion of the guide film GF in the clamping part 700. The control part may control the position of the clamp 770 in real time based on the result measured by the sensing part 790. In some embodiments, forces applied to at least two parts of the guide film GF may be adjusted to be equal to a preset force.

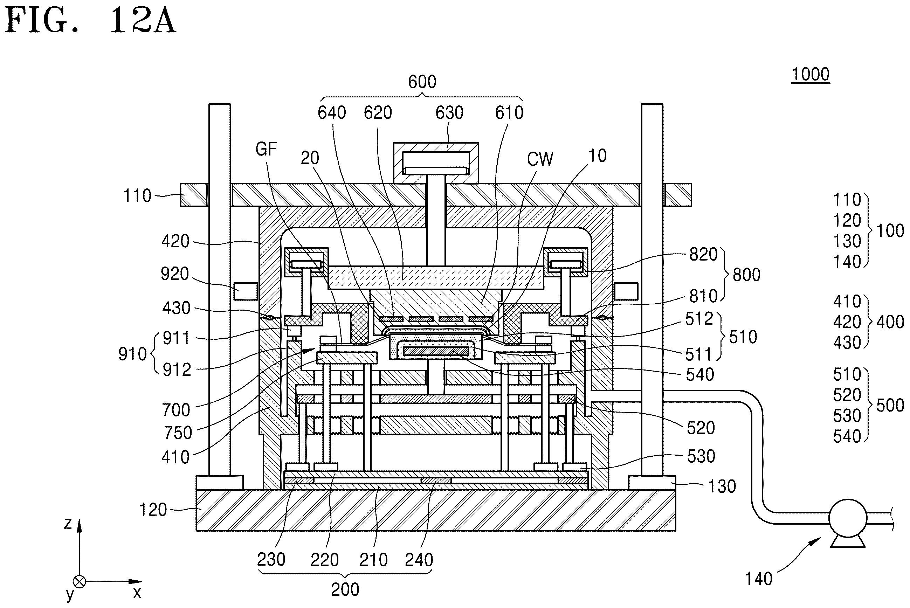

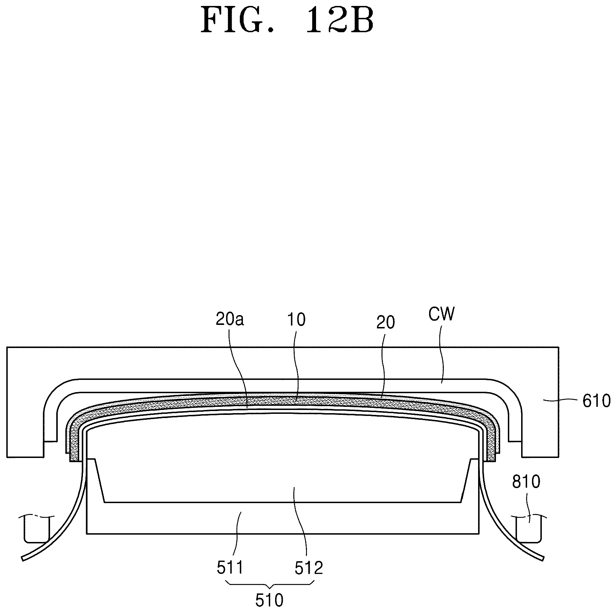

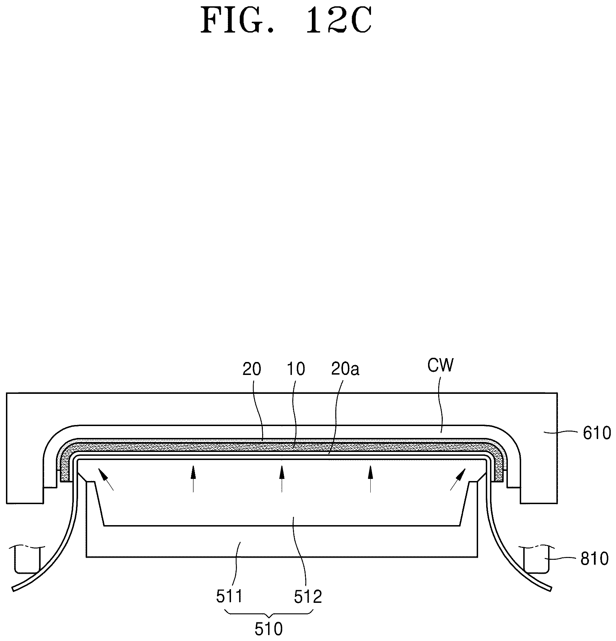

FIGS. 12A to 12C are cross-sectional views schematically illustrating the operation of the apparatus for manufacturing a display device in FIG. 1.

Referring to FIGS. 12A to 12C, the guide film GF may be deformed so that the display panel 10 and the first adhesive layer 20 are primarily deformed, and the second jig 610 may be lowered so that the display panel 10 and the cover window CW are attached to each other through the first adhesive layer 20.

At this time, a portion of the main display area MDA, which is the central portion of the display panel 10, may be bonded to the cover window CW. In the final shape of the display panel 10, a flat surface without a curvature (e.g., the main display area MDA) may be first bonded to the cover window CW. Thereafter, the cover window CW may be bonded to the sub-display area SDA and the corner display area CDA of the display panel 10 having a curvature. The process of bonding the cover window CW to the sub-display area SDA and the corner display area CDA may be performed simultaneously. For example, when bonding the sub-display area SDA to the cover window CW, the corner display area CDA may be naturally bonded to the cover window CW by a surrounding external force. As an example, the process of bonding the sub-display area SDA and the corner display area CDA to the cover window CW may be performed at different timings. For example, after the sub-display area SDA and the cover window CW are bonded to each other, the corner display area CDA and the cover window CW may be bonded to each other.

In this case, the shape of the pad part 512 may be changed so that the pad part 512 is connected to the flat portion of the cover window CW. The display panel 10 may be attached without bubbles not only at the portion where the curve starts but also on the curved surface of the cover window CW.

While the above-described process is in progress, the pressure control part 140 may discharge gas from the space shielded by the first chamber 410, the second chamber 420, and the sealing part 430 to the outside. Accordingly, the bonding quality of the cover window CW and the display panel 10 may be improved by preventing foreign materials or gases from being disposed between the cover window CW and the first adhesive layer 20.

When the second jig 610 is lowered, the guide driving part 820 may also be lowered. At this time, the guide 810 may not be lowered because the position of the guide 810 is fixed by the stopper part 910. The guide driving part 820 may be lowered together with the second jig 610, even when the position of the guide 810 does not change because internal gas is compressed by the stopper part 910.

After the display panel 10 is bonded to the cover window CW, the display panel 10 to which the cover window CW is attached may be separated from the second jig 610. Thereafter, the display panel 10 to which the cover window CW and the guide film GF are attached may be unloaded, and the guide film GF may be removed from the display panel 10. At this time, the second adhesive layer 20a on the guide film GF and the display panel 10 may be separated from each other in various ways. In an embodiment, when the second adhesive layer 20a to which the guide film GF and the display panel 10 are attached is implemented as an ultraviolet (UV) adhesive sheet, the guide film GF and the display panel 10 may be separated from each other by irradiating UV light onto the second adhesive layer 20a. For example, when UV light is irradiated onto the second adhesive layer 20a, the adhesive force between the second adhesive layer 20a and the display panel 10 becomes relatively weak, and thus, the guide film GF and the display panel 10 may be separated from each other. In an embodiment, the adhesive force between the second adhesive layer 20a and the display panel 10 becomes relatively weak, and thus, the second adhesive layer 20a may remain on the guide film GF. In an embodiment, the adhesive force between the second adhesive layer 20a and the guide film GF may become relatively weak. In this case, the second adhesive layer 20a may remain on the display panel 10.

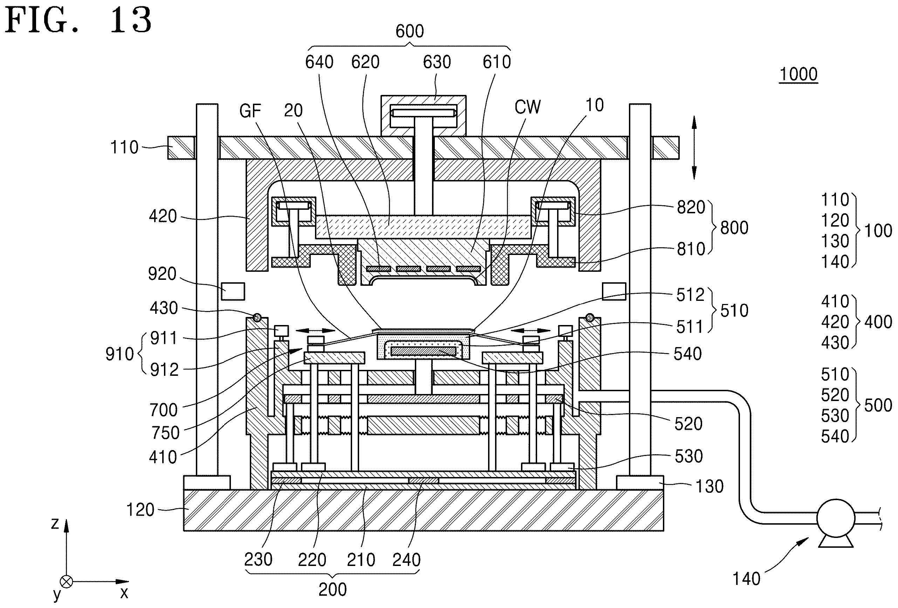

FIG. 13 is a cross-sectional view schematically illustrating the operation of the apparatus for manufacturing a display device in FIG. 1.

Referring to FIG. 13, the apparatus 1000 for manufacturing a display device may also operate differently from that described with reference to FIGS. 5A to 12C.

Specifically, as described with reference to FIG. 5A, the guide film GF on which the display panel 10 and the first adhesive layer 20 are disposed may be fixed by the clamping part 700 and the first jig 510, and the cover window CW may be seated on the second jig 610. Furthermore, the first heating part 540 and the second heating part 640 may operate to increase the temperature of the display panel 10 and the temperature of the cover window CW respectively.

As illustrated in FIG. 13, the first jig driving part 530 may operate to raise the first moving plate 520 and the first jig 510. Accordingly, the guide film GF, and the display panel 10 and the first adhesive layer 20 on the guide film GF may be primarily deformed (e.g., portions thereof may be bent).

When the above-described process is completed, the first jig 510 and the cover window CW may be aligned with each other, as described with reference to FIG. 8. Furthermore, as described with reference to FIG. 8, the cover window CW and the display panel 10 may be aligned with each other, or the display panel 10 and the second jig 610 may be aligned with each other.

Thereafter, as described with reference to FIG. 9, the driving part 130 may operate to form the space shielded by the first chamber 410, the second chamber 420, and the sealing part 430. As described with reference to FIGS. 10 and 11A, the guide driving part 820 may operate to lower the guide 810 so that the guide 810 comes into contact with the guide film GF, and thus, the guide film GF may come into close contact with the side surface of the first jig 510. In this case, as described with reference to FIGS. 11A to 11C, the display panel 10 and the first adhesive layer 20 on the guide film GF may be deformed.

As described with reference to FIGS. 12A to 12C, when the above-described process is completed, the cover window CW and the display panel 10 may be attached to each other through the first adhesive layer 20 by applying pressure to the cover window CW and the display panel 10 through the second jig driving part 630. At this time, the pressure control part 140 may discharge the gas inside the first chamber 410 and the second chamber 420, thereby improving the bonding quality.

As described with reference to FIGS. 3A to 3C, when the above-described process is performed, the sensing part 790 may detect the force with which the clamping part 700 pulls the guide film GF, and the control part may control the first clamp driving part 710 based on the result detected by the sensing part 790. At this time, because the method by which the control part controls the first clamp driving part 710 is identical to or similar to that described with reference to FIGS. 3A to 3C, a detailed description thereof is omitted.

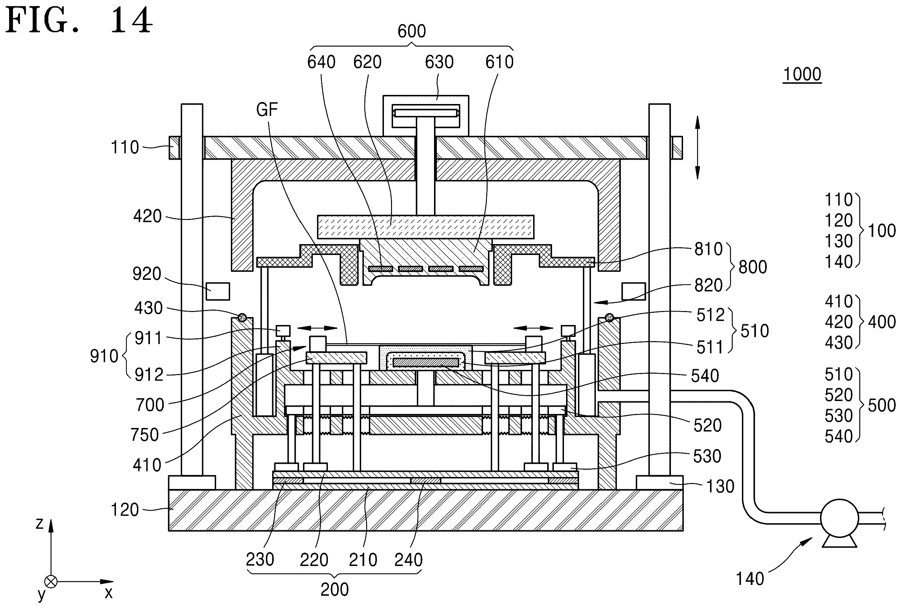

FIG. 14 is a cross-sectional view schematically illustrating an apparatus 1000 for manufacturing a display device, according to an embodiment.

Referring to FIG. 14, the apparatus 1000 for manufacturing a display device may include a base part 100, an alignment part 200, a chamber part 400, a first jig part 500, a second jig part 600, a guide part 800, a stopper part 910, and a vision part 920. The base part 100 may include a first support 110, a second support 120, a driving part 130, and a pressure control part 140. The alignment part 200 may include a first alignment stage 210, a second alignment stage 220, a first alignment driving part 230, and a first connection part 240. The chamber part 400 may include a first chamber 410, a second chamber 420, and a sealing part 430. The first jig part 500 may include a first jig 510, a first moving plate 520, a first jig driving part 530, and a first heating part 540. The second jig part 600 may include a second jig 610, a second moving plate 620, a second jig driving part 630, and a second heating part 640. The guide part 800 may include a guide 810 and a guide driving part 820. The stopper part 910 may include a stopper support 912 and a stopper 911. The base part 100, the alignment part 200, the chamber part 400, the first jig part 500, the second jig part 600, the stopper part 910, and the vision part 920 may be identical to or similar to those described with reference to FIG. 1. For convenience of explanation, the differences from FIG. 1 are mainly described in detail.

Because the guide 810 is identical or similar to the guide 810 described with reference to FIG. 1, a detailed description thereof is omitted.

The guide driving part 820 may be disposed in the first chamber 410. In this case, the guide driving part 820 may operate independently from the motion of the second jig 610.

The operation of the apparatus 1000 for manufacturing a display device may be similar to that described with reference to FIGS. 5A to 12C, or may be similar to that described with reference to FIG. 13.

Specifically, the operations of the first chamber 410, the second chamber 420, the first jig 510, the second jig 610, and the pressure control part 140 may be the same as those described with reference to FIGS. 5A to 12C.

As described with reference to FIG. 11A, the first jig 510 may be raised to bend the guide film GF, and the guide 810 may be lowered to come into contact with the guide film GF before the second jig 610. At this time, the guide driving part 820 may operate, and the guide driving part 820 may lower the guide 810 when the second chamber 420 is lowered or after the second chamber 420 is lowered. The guide 810 may be lowered according to the operation of the guide driving part 820, and may come into contact with the stopper part 910.

After the guide 810 comes into contact with the guide film GF, the second jig driving part 630 may operate as illustrated in FIGS. 12A to 12C to attach the display panel 10 to the cover window CW by the first jig 510 and the second jig 610. At this time, the pressure control part 140 may operate to move gas and/or foreign materials between the display panel 10 and the cover window CW to the outside of the first chamber 410 and the second chamber 420.

In an embodiment, as described with reference to FIG. 13, the first jig 510 may be raised to bend the guide film GF, and the guide 810 may be lowered to come into contact with the guide film GF before the second jig 610. Thereafter, the second jig driving part 630 may operate to attach the display panel 10 to the cover window CW by the first jig 510 and the second jig 610. At this time, the pressure control part 140 may operate to move gas and/or foreign materials between the display panel 10 and the cover window CW to the outside of the first chamber 410 and the second chamber 420.

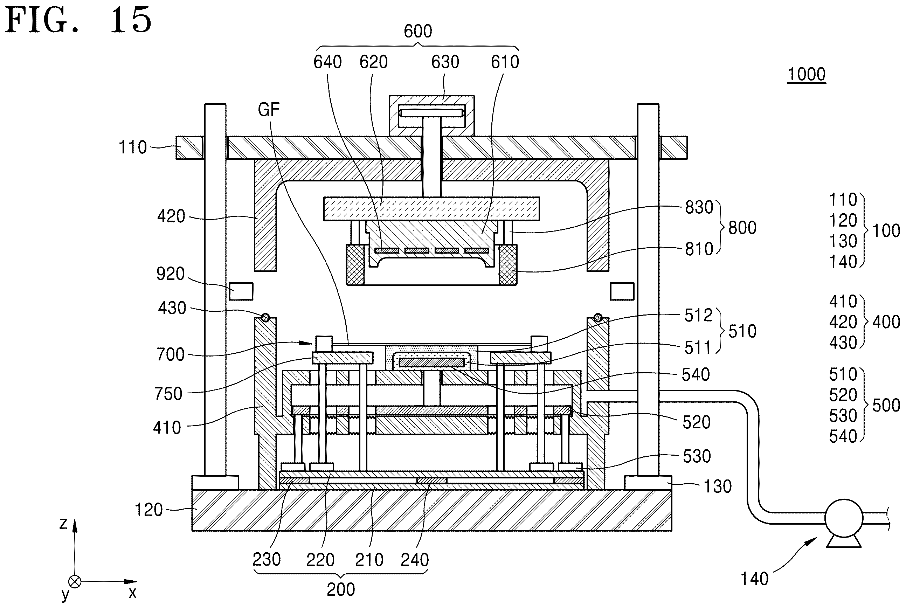

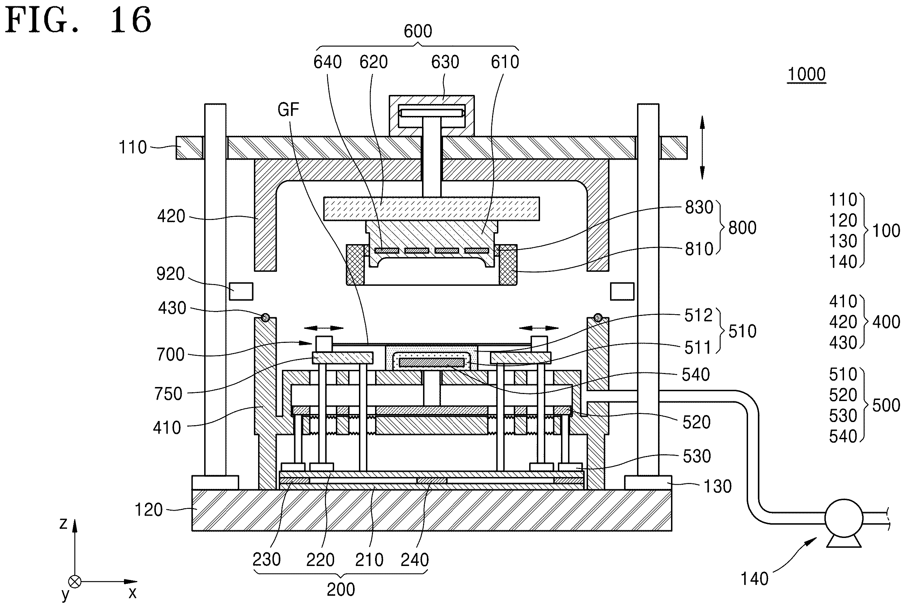

FIG. 15 is a cross-sectional view schematically illustrating an apparatus 1000 for manufacturing a display device, according to an embodiment. FIG. 16 is a cross-sectional view schematically illustrating an apparatus 1000 for manufacturing a display device, according to an embodiment.

Referring to FIGS. 15 and 16, the apparatus 1000 for manufacturing a display device may include a base part 100, an alignment part 200, a chamber part 400, a first jig part 500, a second jig part 600, a guide part 800, and a vision part 920. The base part 100 may include a first support 110, a second support 120, a driving part 130, and a pressure control part 140. The alignment part 200 may include a first alignment stage 210, a second alignment stage 220, a first alignment driving part 230, and a first connection part 240. The chamber part 400 may include a first chamber 410, a second chamber 420, and a sealing part 430. The first jig part 500 may include a first jig 510, a first moving plate 520, a first jig driving part 530, and a first heating part 540. The second jig part 600 may include a second jig 610, a second moving plate 620, a second jig driving part 630, and a second heating part 640. The base part 100, the alignment part 200, the chamber part 400, the first jig part 500, the second jig part 600, and the vision part 920 may be identical to or similar to those described with reference to FIG. 1. For convenience of explanation, the differences from FIG. 1 are mainly described in detail.

The guide part 800 may be fixed to the second jig part 600. For example, as illustrated in FIG. 15, the guide part 800 may include a guide connection part 830 connected to the second moving plate 620, and a guide 810 connected to the guide connection part 830 and having a portion protruding from the lower surface of the second jig 610. In an embodiment, as illustrated in FIG. 16, the guide part 800 may be connected to the second jig 610. The guide part 800 may include a guide connection part 830 connected to the second jig 610, and a guide 810 connected to the guide connection part 830 and having a portion protruding from the lower surface of the second jig 610.

The apparatus 1000 for manufacturing a display device may perform a process similar to the process described with reference to FIG. 5A to 12C or the process described with reference to FIG. 13.

For example, after the processes of FIGS. 5A to 10 are performed, the guide 810 may be lowered together when the second jig driving part 630 operates to lower the second jig 610. At this time, when the second jig 610 continues to be lowered, the guide 810 protruding from the lower surface of the second jig 610 may first come into contact with the guide film GF so that the guide film GF, the display panel 10, and the first adhesive layer 20 are deformed, as described with reference to FIG. 11A.

Thereafter, when the second jig 610 continues to be lowered, the display panel 10 may be attached to the cover window CW in a state where the guide film GF, the display panel 10, and the first adhesive layer 20 are deformed, as described with reference to FIGS. 12A to 12C. At this time, the pressure control part 140 may operate to move gas and/or foreign materials between the display panel 10 and the cover window CW to the outside of the first chamber 410 and the second chamber 420.

As described with reference to FIGS. 3A to 3C, when the above-described process is performed, the sensing part 790 may detect the force with which the clamping part 700 pulls the guide film GF, and the control part may control the first clamp driving part 710 based on the result detected by the sensing part 790. At this time, because the method by which the control part controls the first clamp driving part 710 is identical to or similar to that described with reference to FIGS. 3A to 3C, a detailed description thereof is omitted.

In an embodiment, as described with reference to FIG. 13, the first jig driving part 530 may operate to raise the first jig 510 so that the guide film GF, the display panel 10, and the first adhesive layer 20 are deformed, and the second jig driving part 630 may operate to lower the second jig 610. Before the cover window CW comes into contact with the first adhesive layer 20, the guide 810 may come into contact with the deformed guide film GF. When the guide 810 comes into contact with the guide film GF, the guide film GF, the display panel 10, and the first adhesive layer 20 may be deformed more than when the first jig 510 is raised, and may have a shape almost similar to one surface of the cover window CW or the surface of the first jig 510.

Thereafter, when the second jig 610 continues to be lowered, the display panel 10 may be attached to the cover window CW in a state where the guide film GF, the display panel 10, and the first adhesive layer 20 are deformed, as described with reference to FIGS. 12A to 12C. At this time, the pressure control part 140 may operate to move gas and/or foreign materials between the display panel 10 and the cover window CW to the outside of the first chamber 410 and the second chamber 420.

As described with reference to FIGS. 3A to 3C, when the above-described process is performed, the sensing part 790 may detect the force with which the clamping part 700 pulls the guide film GF, and the control part may control the first clamp driving part 710 based on the result detected by the sensing part 790. At this time, because the method by which the control part controls the first clamp driving part 710 is identical to or similar to that described with reference to FIGS. 3A to 3C, a detailed description thereof is omitted.

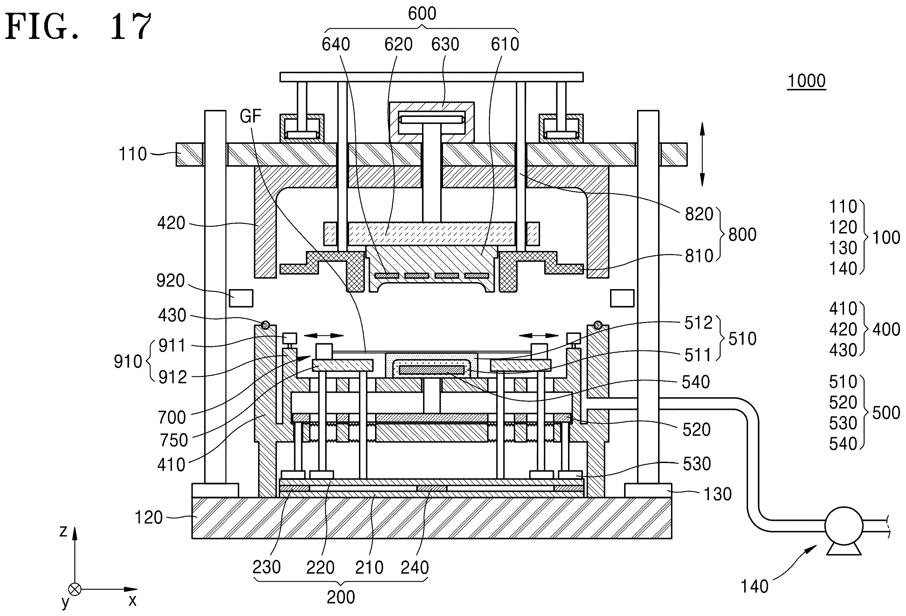

FIG. 17 is a cross-sectional view schematically illustrating an apparatus 1000 for manufacturing a display device, according to an embodiment.

Referring to FIG. 17, the apparatus 1000 for manufacturing a display device may include a base part 100, an alignment part 200, a chamber part 400, a first jig part 500, a second jig part 600, a guide part 800, a stopper part 910, and a vision part 920. The base part 100 may include a first support 110, a second support 120, a driving part 130, and a pressure control part 140. The alignment part 200 may include a first alignment stage 210, a second alignment stage 220, a first alignment driving part 230, and a first connection part 240. The chamber part 400 may include a first chamber 410, a second chamber 420, and a sealing part 430. The first jig part 500 may include a first jig 510, a first moving plate 520, a first jig driving part 530, and a first heating part 540. The second jig part 600 may include a second jig 610, a second moving plate 620, a second jig driving part 630, and a second heating part 640. The guide part 800 may include a guide 810 and a guide driving part 820. The stopper part 910 may include a stopper support 912 and a stopper 911. The base part 100, the alignment part 200, the chamber part 400, the first jig part 500, the second jig part 600, the stopper part 910, and the vision part 920 may be identical to or similar to those described with reference to FIG. 1. For convenience of explanation, the differences from FIG. 1 are mainly described in detail.

Because the guide 810 is identical or similar to the guide 810 described with reference to FIG. 1, a detailed description thereof is omitted.

The guide driving part 820 may be disposed on the first support 110. In this case, the guide driving part 820 may move together with the second jig 610.

The operation of the apparatus 1000 for manufacturing a display device may be similar to that described with reference to FIGS. 5A to 12C, or may be similar to that described with reference to FIG. 13.

Specifically, the operations of the first chamber 410, the second chamber 420, the first jig 510, the second jig 610, and the pressure control part 140 may be the same as those described with reference to FIGS. 5A to 12C.

As described with reference to FIG. 11A, the first jig 510 may be raised to bend the guide film GF, and the guide 810 may be lowered to come into contact with the guide film GF before the second jig 610. In this case, the guide 810 may be lowered according to the operation of the guide driving part 820, and may come into contact with the stopper part 910.

After the guide 810 comes into contact with the guide film GF, the second jig driving part 630 may operate as illustrated in FIGS. 12A to 12C to attach the display panel 10 to the cover window CW by the first jig 510 and the second jig 610. At this time, the gas inside the guide driving part 820 may be compressed, and the position of the guide 810 may be maintained while the guide 810 is in contact with the stopper part 910. Furthermore, the pressure control part 140 may operate to move gas and/or foreign materials between the display panel 10 and the cover window CW to the outside of the first chamber 410 and the second chamber 420.

In an embodiment, as described with reference to FIG. 13, the first jig 510 may be raised to bend the guide film GF, and the guide 810 may be lowered to come into contact with the guide film GF before the second jig 610. Thereafter, the second jig driving part 630 may operate to attach the display panel 10 to the cover window CW by the first jig 510 and the second jig 610. At this time, the gas inside the guide driving part 820 may be compressed, and the position of the guide 810 may be maintained while the guide 810 is in contact with the stopper part 910. Furthermore, the pressure control part 140 may operate to move gas and/or foreign materials between the display panel 10 and the cover window CW to the outside of the first chamber 410 and the second chamber 420.

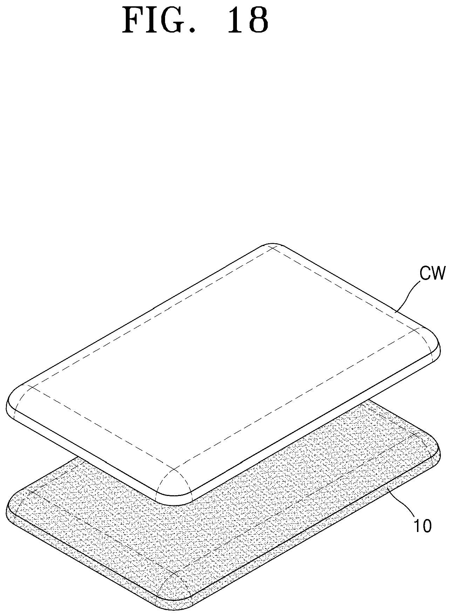

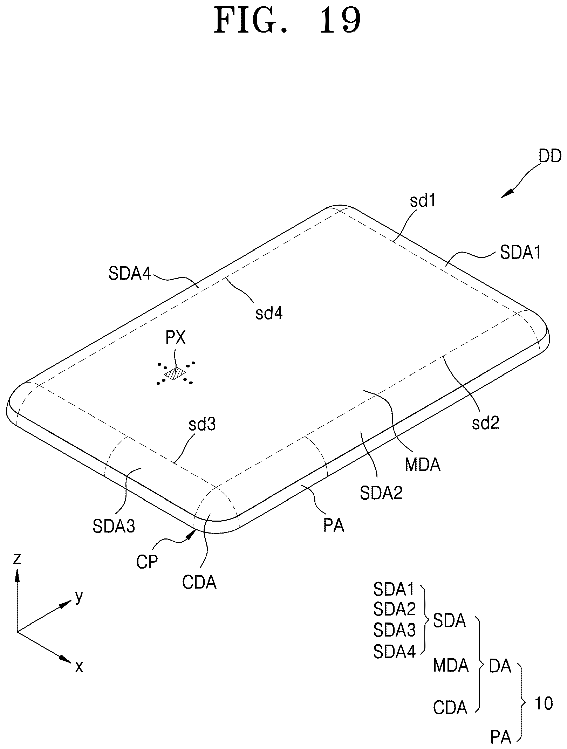

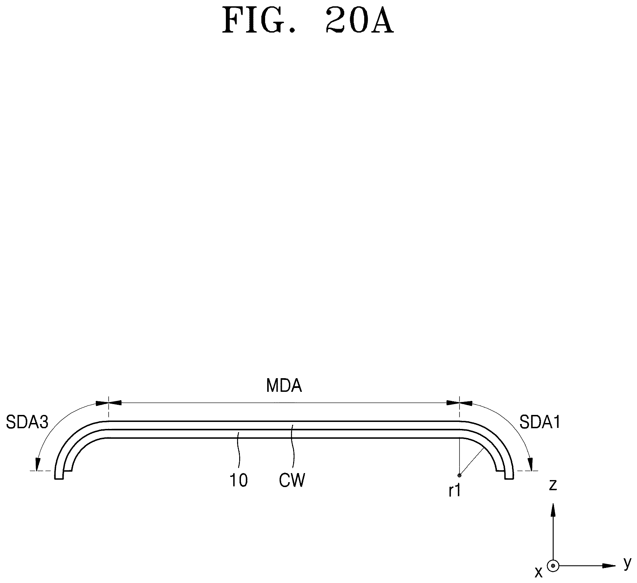

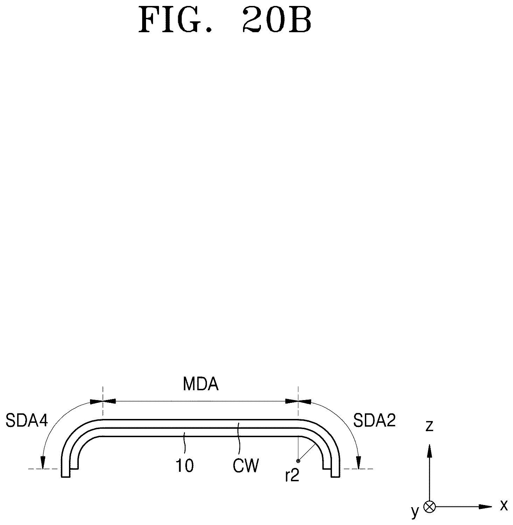

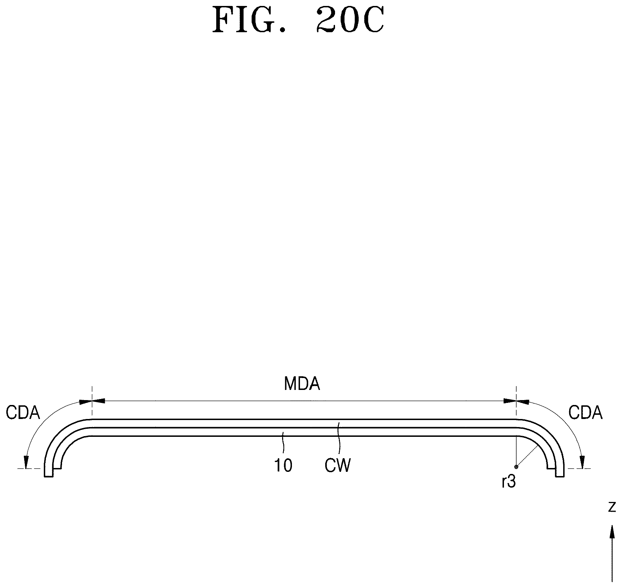

FIG. 18 is an exploded perspective view schematically illustrating a display device according to an embodiment. FIG. 19 is a perspective view schematically illustrating a display device according to an embodiment. FIGS. 20A to 20C are cross-sectional views schematically illustrating the display device illustrated in FIG. 19.

Referring to FIGS. 18 to 20C, a display device DD may have a long side in a first direction and a short side in a second direction. The first direction and the second direction may cross each other. For example, the first direction and the second direction may form an acute angle. As an example, the first direction and the second direction may form an obtuse angle or a right angle. Hereinafter, a case where the first direction (e.g., a y direction) and the second direction (e.g., an x direction) form a right angle is described in detail.

In an embodiment, in the display device DD, the length of the side in the first direction (e.g., the y direction) may be equal to the length of the side in the second direction (e.g., the x direction). In an embodiment, the display device DD may have a short side in the first direction (e.g., the y direction) and a long side in the second direction (e.g., the x direction).

A corner where the long side in the first direction (e.g., the y direction) meets the short side in the second direction (e.g., the x direction) may be round to have a certain curvature.

The display device DD may include a display panel 10 and a cover window CW. The cover window CW may protect the display panel 10.

The cover window CW may be a flexible window. The cover window CW may be easily bent according to an external force without causing cracks or the like, thereby protecting the display panel 10. The cover window CW may include glass, sapphire, or plastic. For example, the cover window CW may include ultra-thin glass (UTG) and colorless polyimide (CPI). In an embodiment, the cover window CW may have a structure in which a flexible polymer layer is disposed on one surface of a glass substrate, or may include only a polymer layer.

The display panel 10 may be disposed below the cover window CW. Although not illustrated in FIGS. 20A to 20C, the display panel 10 may be attached to the cover window CW by a transparent adhesive member, such as an OCA film.

The display panel 10 may include a display area DA in which an image is displayed and a peripheral area PA surrounding the display area DA. The display area DA may include a plurality of pixels PX, and an image may be displayed through the plurality of pixels PX. The plurality of pixels PX may each include sub-pixels. For example, the plurality of pixels PX may each include a red sub-pixel, a green sub-pixel, and a blue sub-pixel. In another example, the plurality of pixels PX may each include a red sub-pixel, a green sub-pixel, a blue sub-pixel, and a white sub-pixel.

The display area DA may include a main display area MDA, a sub-display area SDA, and a corner display area CDA. The main display area MDA, the sub-display area SDA, and the corner display area CDA may each include a plurality of pixels PX, and the plurality of pixels PX may display an image.

For example, the plurality of pixels PX disposed in the main display area MDA, the sub-display area SDA, and the corner display area CDA may each provide an independent image. As an example, the plurality of pixels PX disposed in the main display area MDA, the sub-display area SDA, and the corner display area CDA may each provide a portion of an image.

The main display area MDA is a flat display area that may include a pixel PX including a display element. The main display area MDA may provide most of the image.

The pixel PX including the display element may also be disposed in the sub-display area SDA. The sub-display area SDA may display an image by the pixel PX. The sub-display area SDA may include a first sub-display area SDA1, a second sub-display area SDA2, a third sub-display area SDA3, and a fourth sub-display area SDA4. At least one of the first sub-display area SDA1, the second sub-display area SDA2, the third sub-display area SDA3, or the fourth sub-display area SDA4 may be omitted.

The first sub-display area SDA1 and the third sub-display area SDA3 may be connected to the main display area MDA in the first direction (e.g., the y direction). For example, the first sub-display area SDA1 may be extended in the +y direction from the main display area MDA, and the third sub-display area SDA3 may be extended in the -y direction from the main display area MDA. The first sub-display area SDA1 may be connected to a first side sd1 of the main display area MDA, and the third sub-display area SDA3 may be connected to a third side sd3 of the main display area MDA.

The first sub-display area SDA1 and the third sub-display area SDA3 may each be bent with an arbitrary radius of curvature. For example, the radii of curvature of the first sub-display area SDA1 and the third sub-display area SDA3 may be different from each other. As an example, the radii of curvature of the first sub-display area SDA1 and the third sub-display area SDA3 may be identical to each other. Hereinafter, a case where the radii of curvature of the first sub-display area SDA1 and the third sub-display area SDA3 are equal to a first radius r1 of curvature is mainly described in detail. Furthermore, because the first sub-display area SDA1 and the third sub-display area SDA3 are identical to or similar to each other, the first sub-display area SDA1 is mainly described in detail.

The second sub-display area SDA2 and the fourth sub-display area SDA4 may be connected to the main display area MDA in the second direction (e.g., the x direction). For example, the second sub-display area SDA2 may be extended in the +x direction from the main display area MDA, and the fourth sub-display area SDA4 may be extended in the -x direction from the main display area MDA.

The second sub-display area SDA2 and the fourth sub-display area SDA4 may each be bent with an arbitrary radius of curvature. For example, the radii of curvature of the second sub-display area SDA2 and the fourth sub-display area SDA4 may be different from each other. As an example, the radii of curvature of the second sub-display area SDA2 and the fourth sub-display area SDA4 may be identical to each other. Hereinafter, a case where the radii of curvature of the second sub-display area SDA2 and the fourth sub-display area SDA4 are equal to a second radius r2 of curvature is mainly described in detail. Furthermore, because the second sub-display area SDA2 and the fourth sub-display area SDA4 are identical to or similar to each other, the second sub-display area SDA2 is mainly described in detail.

In an embodiment, the first radius r1 of curvature of the first sub-display area SDA1 may be different from the second radius r2 of curvature of the second sub-display area SDA2. For example, the first radius r1 of curvature may be less than the second radius r2 of curvature. As an example, the first radius r1 of curvature may be greater than the second radius r2 of curvature.

In an embodiment, the first radius r1 of curvature of the first sub-display area SDA1 may be equal to the second radius r2 of curvature of the second sub-display area SDA2. Hereinafter, a case where the first radius r1 of curvature is greater than the second radius r2 of curvature is mainly described in detail.

The corner display area CDA may extend from the corner of the main display area MDA and be bent. The corner display area CDA may be disposed to correspond to a corner portion CP. The corner portion CP is a corner of the display area DA, and may be a portion where the long side of the display area DA in the first direction (e.g., the y direction) meets the short side in the second direction (e.g., the x direction).

The corner display area CDA may be disposed between the adjacent sub-display areas SDA. For example, the corner display area CDA may be disposed between the first sub-display area SDA1 and the second sub-display area SDA2. The corner display area CDA may be disposed between the second sub-display area SDA2 and the third sub-display area SDA3, between the third sub-display area SDA3 and the fourth sub-display area SDA4, or between the fourth sub-display area SDA4 and the first sub-display area SDA1. Accordingly, the sub-display area SDA and the corner display area CDA may be disposed to surround the main display area MDA, and may each be bent with an arbitrary radius of curvature.

A third radius r3 of curvature of the corner display area CDA may be changed. For example, when the first radius r1 of curvature of the first sub-display area SDA1 is different from the second radius r2 of curvature of the second sub-display area SDA2, the third radius r3 of curvature of the corner display area CDA may be gradually changed within a range between the first radius r1 of curvature and the second radius r2 of curvature.

In an embodiment, when the first radius r1 of curvature of the first sub-display area SDA1 is greater than the second radius r2 of curvature of the second sub-display area SDA2, the third radius r3 of curvature of the corner display area CDA may gradually decrease in a direction from the first sub-display area SDA1 to the second sub-display area SDA2. For example, the third radius r3 of curvature of the corner display area CDA may be less than the first radius r1 of curvature and greater than the second radius r2 of curvature.

In an embodiment, the display device DD may display an image not only in the main display area MDA, but also in the sub-display area SDA and the corner display area CDA. Accordingly, the proportion of the display area DA in the display devices DD may increase. Furthermore, the display device DD may be curved at the corners and include the corner display area CDA that enables an image to be displayed, thereby improving aesthetics.

However, the cover window CW is not limited to the shape illustrated in FIG. 18. For example, although not illustrated, the entire surface of the cover window CW may be curved. For example, the cover window CW may be in the form of a portion of a sphere. At this time, the cross-section of the cover window CW may have a constant radius of curvature. In an embodiment, the cover window CW may be in the form of a portion of an ellipsoid. In this case, the cross-section of the cover window CW may be in the form of a plurality of connected curves having different radii of curvature.

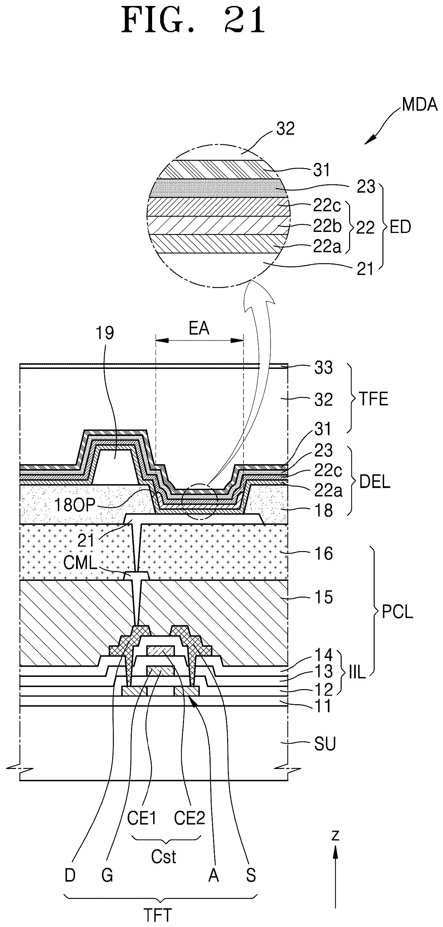

FIG. 21 is a cross-sectional view schematically illustrating a portion of the display area of the display panel illustrated in FIG. 19.

Referring to FIG. 21, the display panel may include a substrate SU, a buffer layer 11, a pixel circuit layer PCL, a display element layer DEL, and a thin-film encapsulation layer TFE.

The substrate SU may include glass or polymer resin, such as polyethersulfone, polyarylate, polyetherimide, polyethylene naphthalate, polyethylene terephthalate, polyphenylene sulfide, polyimide, polycarbonate, cellulose triacetate, or cellulose acetate propionate. The substrate SU including the polymer resin may be flexible, rollable, or bendable. The substrate SU may have a multilayer structure that includes a barrier layer (not shown) and a base layer including the polymer resin described above.

The buffer layer 11 may include an inorganic insulating material, such as silicon nitride, silicon oxynitride, or silicon oxide, and may include a single layer or multilayers including the inorganic insulating material described above.

The pixel circuit layer PCL may be disposed on the buffer layer 11. The pixel circuit layer PCL may include a thin-film transistor TFT included in a pixel circuit and may include an inorganic insulating layer IIL, a first planarization layer 15, and a second planarization layer 16, which are disposed below and/or above components of the thin-film transistor TFT. The inorganic insulating layer IIL may include a first gate insulating layer 12, a second gate insulating layer 13, and an interlayer insulating layer 14.

The thin-film transistor TFT may include a semiconductor layer A, and the semiconductor layer A may include polysilicon. In an example, the semiconductor layer A may include amorphous silicon, an oxide semiconductor, or an organic semiconductor. The semiconductor layer A may include a channel region, and a drain region and a source region respectively on both sides of the channel region. A gate electrode G may overlap the channel region.

The gate electrode G may include a low-resistance metal material. The gate electrode G may include a conductive material including molybdenum (Mo), aluminum (Al), copper (Cu), titanium (Ti), and the like, and may include a single layer or multilayers including the conductive material described above.

The first gate insulating layer 12 between the semiconductor layer A and the gate electrode G may include an inorganic insulating material, such as silicon oxide (SiO₂), silicon nitride (SiNₓ), silicon oxynitride (SiOₓN_{y}), aluminum oxide (Al₂O₃), titanium oxide (TiO₂), tantalum oxide (Ta₂O₅), hafnium oxide (HfO₂), and/or zinc oxide (ZnOₓ). In this case, zinc oxide (ZnOₓ) may be ZnO and/or ZnO₂.

The second gate insulating layer 13 may cover the gate electrode G. Similar to the first gate insulating layer 12, the second gate insulating layer 13 may include an inorganic insulating material, such as silicon oxide (SiO₂), silicon nitride (SiNₓ), silicon oxynitride (SiOₓN_{y}), aluminum oxide (Al₂O₃), titanium oxide (TiO₂), tantalum oxide (Ta₂O₅), hafnium oxide (HfO₂), and/or zinc oxide (ZnOₓ). In this case, zinc oxide (ZnOₓ) may be ZnO and/or ZnO₂.

An upper electrode CE2 of a storage capacitor Cst may be disposed on the second gate insulating layer 13. The upper electrode CE2 may overlap the gate electrode G therebelow. In this case, the gate electrode G and the upper electrode CE2, which overlap each other with the second gate insulating layer 13 therebetween, may constitute the storage capacitor Cst. That is, the gate electrode G may function as a lower electrode CE1 of the storage capacitor Cst. As described above, the storage capacitor Cst and the thin-film transistor TFT may overlap each other. In some embodiments, the storage capacitor Cst may not overlap the thin-film transistor TFT.

The upper electrode CE2 may include aluminum (Al), platinum (Pt), palladium (Pd), silver (Ag), magnesium (Mg), gold (Au), nickel (Ni), neodymium (Nd), iridium (Ir), chromium (Cr), calcium (Ca), molybdenum (Mo), titanium (Ti), tungsten (W), and/or copper (Cu) and may include a single layer or multilayers including the material described above.

The interlayer insulating layer 14 may cover the upper electrode CE2. The interlayer insulating layer 14 may include silicon oxide (SiO₂), silicon nitride (SiNₓ), silicon oxynitride (SiOₓN_{y}), aluminum oxide (Al₂O₃), titanium oxide (TiO₂), tantalum oxide (Ta₂O₅), hafnium oxide (HfO₂), and/or zinc oxide (ZnOₓ). In this case, zinc oxide (ZnOₓ) may be ZnO and/or ZnO₂. The interlayer insulating layer 14 may include a single layer or multilayers including the inorganic insulating material described above.

A drain electrode D and a source electrode S may be disposed on the interlayer insulating layer 14. The drain electrode D and the source electrode S may each include a material having good conductivity. The drain electrode D and the source electrode S may each include a conductive material including molybdenum (Mo), aluminum (Al), copper (Cu), and/or titanium (Ti), and may each include a single layer or multilayers including the conductive material described above. In an embodiment, the drain electrode D and the source electrode S may each have a multilayer structure of Ti/Al/Ti.

The first planarization layer 15 may be disposed to cover the drain electrode D and the source electrode S. The first planarization layer 15 may include an organic insulating material. The first planarization layer 15 may include an organic insulating material, for example, general-purpose polymer such as polymethylmethacrylate (PMMA) or polystyrene (PS), polymer derivatives having a phenolic group, acrylic polymer, imide-based polymer, aryl ether-based polymer, amide-based polymer, fluorine-based polymer, p-xylene-based polymer, vinyl alcohol-based polymer, and/or any blend thereof.

A connection electrode CML may be disposed on the first planarization layer 15. At this time, the connection electrode CML may be connected to the drain electrode D or the source electrode S through a contact hole of the first planarization layer 15. The connection electrode CML may include a material having good conductivity. The connection electrode CML may include a conductive material including molybdenum (Mo), aluminum (Al), copper (Cu), and/or titanium (Ti), and may include a single layer or multilayers including the conductive material described above. In an embodiment, the connection electrode CML may have a multilayer structure of Ti/Al/Ti.

The second planarization layer 16 may be disposed to cover the connection electrode CML. The second planarization layer 16 may include an organic insulating layer. The second planarization layer 16 may include an organic insulating material, for example, general-purpose polymer such as polymethylmethacrylate (PMMA) or polystyrene (PS), polymer derivatives having a phenolic group, acrylic polymer, imide-based polymer, aryl ether-based polymer, amide-based polymer, fluorine-based polymer, p-xylene-based polymer, vinyl alcohol-based polymer, and/or any blend thereof.

The display element layer DEL may be disposed on the pixel circuit layer PCL. The display element layer DEL may include a display element ED. The display element ED may be an organic light-emitting diode (OLED). A pixel electrode 21 of the display element ED may be electrically connected to the connection electrode CML through a contact hole of the second planarization layer 16.

The pixel electrode 21 may include a conductive oxide, such as indium tin oxide (ITO), indium zinc oxide (IZO), zinc oxide (ZnO), indium oxide (In₂O₃), indium gallium oxide (IGO), and/or aluminum zinc oxide (AZO). In an embodiment, the pixel electrode 21 may include a reflective layer including silver (Ag), magnesium (Mg), aluminum (Al), platinum (Pt), palladium (Pd), gold (Au), nickel (Ni), neodymium (Nd), iridium (Ir), chromium (Cr), and/or any compound thereof. In an embodiment, the pixel electrode 21 may further include a layer including ITO, IZO, ZnO, and/or In₂O₃ above and/or below the reflective layer.

A bank layer 18 having an opening 18OP exposing the central portion of the pixel electrode 21 may be disposed on the pixel electrode 21. The bank layer 18 may include an organic insulating material and/or an inorganic insulating material. The opening 18OP may define an emission area for light emitted from the display element ED (hereinafter referred to as an emission area EA). For example, the width of the opening 18OP may correspond to the width of the emission area EA of the display element ED.

A spacer 19 may be disposed on the bank layer 18. In a method for manufacturing a display device, the spacer 19 may prevent damage to the substrate SU. A mask sheet may be used when manufacturing the display panel. At this time, when the mask sheet is inserted into the opening 18OP of the bank layer 18 or when the mask sheet is in close contact with the bank layer 18 and a deposition material is deposited on the substrate SU, the spacer 19 may prevent defects in which a portion of the substrate SU is damaged or broken by the mask sheet.

The spacer 19 may include an organic insulating material such as polyimide. In another example, the spacer 19 may include an inorganic insulating material, such as silicon nitride or silicon oxide, or may include an organic insulating material and an inorganic insulating material.

In an embodiment, the spacer 19 may include a material that is different from a material of the bank layer 18. In an embodiment, the spacer 19 and the bank layer 18 may include the same material. In this case, the bank layer 18 and the spacer 19 may be formed together in a mask process using a half-tone mask, etc.

An intermediate layer 22 may be disposed on the bank layer 18. The intermediate layer 22 may include an emission layer 22b disposed in the opening 18OP of the bank layer 18. The emission layer 22b may include a high molecular weight organic material or a low molecular weight organic material that emits light of a certain color.

A first functional layer 22a and a second functional layer 22c may be respectively disposed below and above the emission layer 22b. For example, the first functional layer 22a may include a hole transport layer (HTL), or may include an HTL and a hole injection layer (HIL). The second functional layer 22c may be optionally disposed on the emission layer 22b. The second functional layer 22c may include an electron transport layer (ETL) and/or an electron injection layer (EIL). The first functional layer 22a and/or the second functional layer 22c may be a common layer completely covering the substrate SU, like an opposite electrode 23 to be described below.

The opposite electrode 23 may include a conductive material having a low work function. For example, the opposite electrode 23 may include a transparent layer or a semitransparent layer including silver (Ag), magnesium (Mg), aluminum (Al), platinum (Pt), palladium (Pd), gold (Au), nickel (Ni), neodymium (Nd), iridium (Ir), chromium (Cr), lithium (Li), calcium (Ca), and/or any alloy thereof. In another example, the opposite electrode 23 may further include a layer including ITO, IZO, ZnO, and/or In₂O₃ on the transparent layer or the semitransparent layer including the material described above.

In some embodiments, a capping layer (not shown) may be further disposed on the opposite electrode 23. The capping layer may include an inorganic material (e.g., LiF), or/and an organic material.

A thin-film encapsulation layer TFE may be disposed on the opposite electrode 23. In an embodiment, the thin-film encapsulation layer TFE may include at least one inorganic encapsulation layer and at least one organic encapsulation layer. FIG. 21 illustrates that the thin-film encapsulation layer TFE includes a first inorganic encapsulation layer 31, an organic encapsulation layer 32, and a second inorganic encapsulation layer 33, which are sequentially stacked in this stated order.

The first inorganic encapsulation layer 31 and the second inorganic encapsulation layer 33 may each include at least one inorganic material selected from aluminum oxide, titanium oxide, tantalum oxide, hafnium oxide, zinc oxide, silicon oxide, silicon nitride, and silicon oxynitride. The organic encapsulation layer 32 may include a polymer-based material. The polymer-based material may include acrylic-based resin, epoxy-based resin, polyimide, polyethylene, and the like. In an embodiment, the organic encapsulation layer 32 may include acrylate.

Although not illustrated, a touch electrode layer may be disposed on the thin-film encapsulation layer TFE, and an optical functional layer may be disposed on the touch electrode layer. The touch electrode layer may be configured to obtain coordinate information according to an external input, for example, a touch event. The optical functional layer may reduce the reflectance of light (e.g., external light) incident from the outside toward the display device, and/or may improve the color purity of light emitted from the display device. In an embodiment, the optical functional layer may include a retarder and/or a polarizer. The retarder may be a film-type retarder or a liquid crystal coating-type retarder and may include a λ/2 retarder and/or a λ/4 retarder. The polarizer may be a film-type polarizer or a liquid crystal coating-type polarizer. The film-type retarder or polarizer may include a stretched synthetic resin film, and the liquid crystal coating-type retarder or polarizer may include liquid crystals disposed in a certain array. Each of the retarder and the polarizer may further include a protection film.

In an embodiment, the optical function layer may include a black matrix and color filters. The color filters may be disposed based on the color of light emitted from each pixel of the display device. Each of the color filters may include a red, green, or blue pigment or dye. In other embodiments, each of the color filters may further include, in addition to the pigment or dye, quantum dots. In yet other implementations, some color filters may not include the pigment or dye described above and may include scattering particles, such as titanium oxide.

In an embodiment, the optical functional layer may include a destructive interference structure. The destructive interference structure may include a first reflection layer and a second reflection layer on different layers from each other. First reflected light and second reflected light respectively reflected from the first reflective layer and the second reflective layer may destructively interfere with each other, and thus, the reflectance of external light may be reduced.

An adhesive member may be disposed between the touch electrode layer and the optical function layer. As the adhesive member, any general adhesive member known in the art may be employed without limitation. The adhesive member may be a pressure sensitive adhesive (PSA).

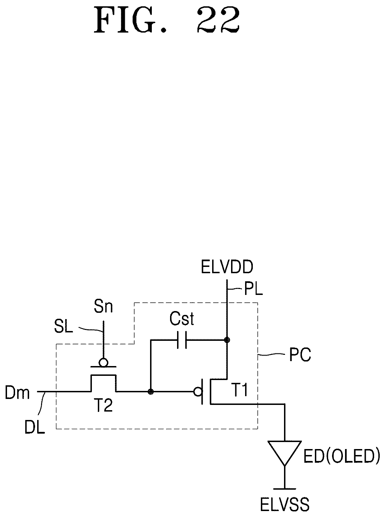

FIG. 22 is a circuit diagram schematically illustrating a sub-pixel circuit of the display panel illustrated in FIG. 19.

Referring to FIG. 22, a sub-pixel circuit PC may include a plurality of thin-film transistors (see TFT of FIG. 21) and a storage capacitor Cst, and may be electrically connected to an organic light-emitting diode OLED, which is a display element ED. In an embodiment, the sub-pixel circuit PC may include a driving thin-film transistor T1, a switching thin-film transistor T2, and a storage capacitor Cst.

The switching thin-film transistor T2 may be connected to a scan line SL and a data line DL and may be configured to transmit, to the driving thin-film transistor T1, a data signal or a data voltage Dm input from the data line DL in response to a scan voltage or a switching signal Sn input from the scan line SL. The storage capacitor Cst may be connected to the switching thin-film transistor T2 and a driving voltage line PL, and may be configured to store a voltage corresponding to a difference between a voltage received from the switching thin-film transistor T2 and a first power supply voltage ELVDD supplied to the driving voltage line PL.

The driving thin-film transistor T1 may be connected to the driving voltage line PL and the storage capacitor Cst and may be configured to control a driving current flowing from the driving voltage line PL to the organic light-emitting diode OLED according to a voltage value stored in the storage capacitor Cst. An opposite electrode (e.g., a cathode) of the organic light-emitting diode OLED may be configured to receive a second power supply voltage ELVSS. The organic light-emitting diode OLED may be configured to externally emit light with a certain luminance according to the driving current.

Although a case where the pixel circuit PC includes two thin-film transistors and one storage capacitor has been described, the disclosure is not limited thereto. For example, the sub-pixel circuit PC may include three or more thin-film transistors and/or two or more storage capacitors. For example, the sub-pixel circuit PC may include seven thin-film transistors and one storage capacitor. The number of thin-film transistors and the number of storage capacitors may be variously changed according to the design of the sub-pixel circuit PC.

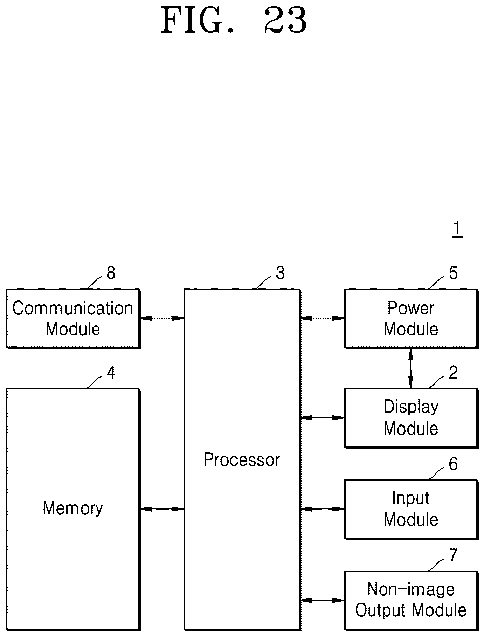

FIG. 23 is a block diagram schematically illustrating an electronic device according to an embodiment.

Referring to FIG. 23, an electronic device 1 according to an embodiment may include a display module 2 including a display panel, a processor 3, a memory 4, and a power module 5.

The processor 3 may include at least one of a central processing unit (CPU), an application processor (AP), a graphics processing unit (GPU), a communication processor (CP), an image signal processor (ISP), or a controller. In an embodiment, the processor 3 may be functionally or structurally divided into two or more parts. For example, the processor 3 may include a main processor in the form of a first driving chip including a CPU and an auxiliary processor in the form of a second driving chip including a controller configured to receive an image signal from the main processor and process the image signal to conform to the interface specifications of the display module 2. The processor 3 may include one or more processors. The one or more processors may execute an application individually, collectively or as a subset of the collective. For example, two out of three processors may carry out instructions together to execute the application.

The memory 4 may include at least one of volatile memory or non-volatile memory. Data information for the operation of the processor 3 or the display module 2 may be stored in the memory 4. When the processor 3 executes an application stored in the memory 4, an image data signal and/or an input control signal may be transmitted to the display module 2, and the display module 2 may process the received signal and output image information on a display screen.

The power module 5 may include a power supply module, such as a power adapter or a battery device, and a power conversion module configured to convert power supplied by the power supply module to generate power for the operation of the electronic device 1. The power conversion by the power conversion module may include direct current (DC)-DC conversion, alternating current (AC)-DC conversion, and DC-AC conversion, but the disclosure is not limited thereto.

The electronic device 1 may further include an input module 6, a non-image output module 7, and/or a communication module 8.

The input module 6 may be configured to provide input information to the processor 3 and/or the display module 2. The input module 6 may include a physical button, a keyboard, a microphone, and other sensor modules. Examples of the sensor modules may include a touch sensor, a pressure sensor, a distance sensor, a position sensor, a digitizer, a motion recognition sensor, a camera sensor, a light-receiving sensor, a photoelectric conversion sensor, a temperature sensor, and a biometric sensor, such as a blood pressure sensor, a blood sugar sensor, an electrocardiogram sensor, or a heart rate sensor.

The non-image output module 7 may be configured to receive non-image information other than the image transmitted from the processor 3 and provide the non-image information to a user. Examples of the non-image output module 7 may include an acoustic module, a haptic module, a light-emitting module, etc., and may include other functional modules unique to the electronic device (e.g., a cooling module of a refrigerator, etc.).

The communication module 8 may be a module responsible for transmitting and receiving information between the electronic device 1 and an external device and may include a receiver and a transmitter. The communication module 8 may include various wireless communication modules, such as a mobile communication module, a Wi-Fi^{™} module, or a Bluetooth module, and various wired communication modules.

At least one of the components of the electronic device 1 may be included in the display device according to the embodiments described above. Furthermore, some of the individual modules functionally included in a single module may be included in the display device, and others may be provided separately from the display device. For example, the display device may include the display module 2, and the processor 3, the memory 4, and the power module 5 may be provided in the form of other devices within the electronic device 1 other than the display device. As an example, the power module 5 may be provided within the display device and configured to supply power to the processor 3 and the memory 4 provided within the electronic device 1 other than the display device, but the disclosure is not limited to the above examples.

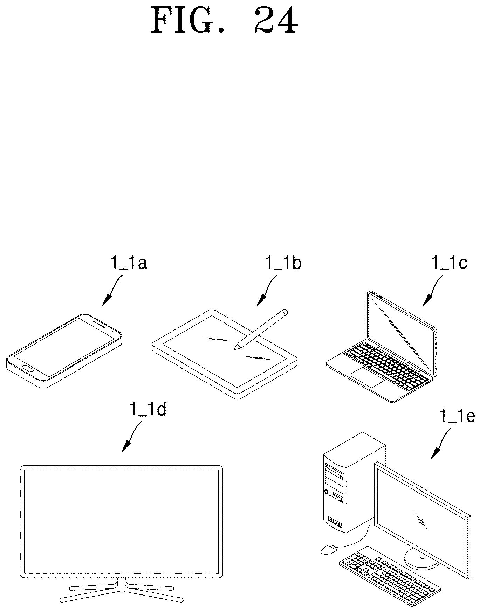

FIGS. 24 to 26 are perspective views schematically illustrating electronic devices according to embodiments. FIGS. 24 to 26 illustrate examples of various electronic devices to which the display device according to embodiments is applied.

FIG. 24 illustrates examples of the electronic device, including a smartphone 1_1a, a tablet personal computer (PC) 1_1b, a laptop 1_1c, a television (TV) 1_1d, and a desk monitor 1_1e.

The smartphone 1_1a may include, in addition to a display module 2, a communication module and an input module, such as a touch sensor. The smartphone 1_1a may be configured to process information received through the communication module or an input module and display the information on the display module of the display device.

Similar to the smartphone 1_1a, the tablet PC 1_1b, the laptop 1_1c, the TV 1_1d, or the desk monitor 1_1e may include a display module and an input module and, in some cases, may further include a communication module.

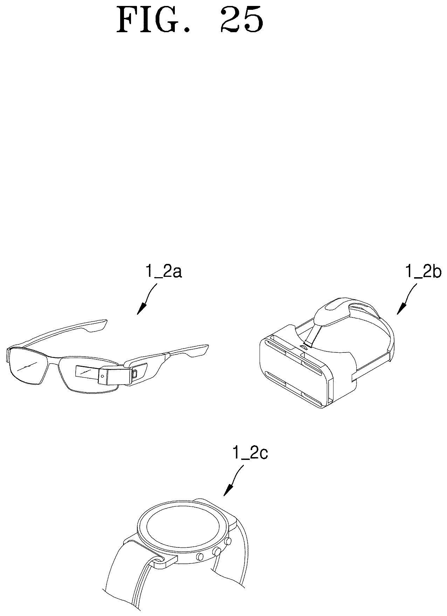

FIG. 25 illustrates examples in which an electronic device including a display module is applied to a wearable electronic device. The wearable electronic device may be smart glasses 1_2a, a head mounted display 1_2b, or a smart watch 1_2c.

Each of the smart glasses 1_2a and the head mounted display 1_2b may include a display module configured to display a display image and a reflector configured to provide the display image to the user's eyes by reflecting the displayed display image, and may provide a virtual reality or augmented reality screen to the user through the display module and the reflector.

The smart watch 1_2c may include a biometric sensor as an input device and may be configured to provide biometric information recognized by the biometric sensor to the user through the display module.

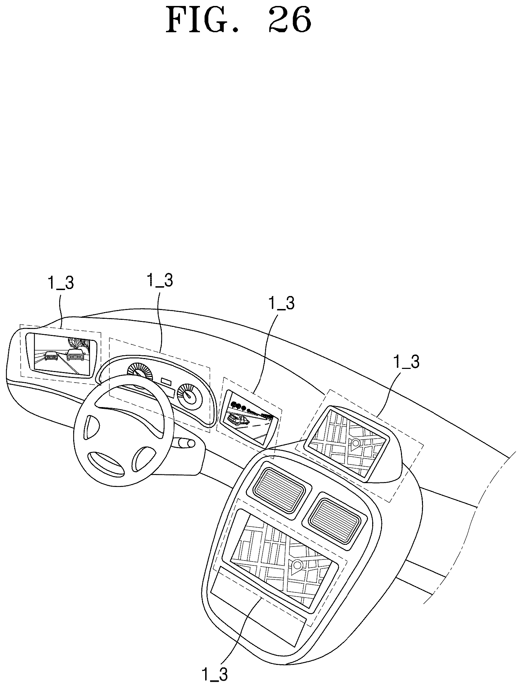

FIG. 26 illustrates an example in which an electronic device including a display module is applied to a vehicle. For example, an electronic device 1_3 may be applied to dashboards, center fascia, etc. of automobiles, or may be applied to center information displays (CIDs) on dashboards of automobiles or room mirror displays replacing side mirrors.

Although not illustrated, the electronic device to which the display device according to embodiments is applied may include screen display-oriented devices, such as billboards, electronic boards, or game consoles, and various home appliances that display information through display modules, such as refrigerators, washing machines, dryers, air conditioners, or robot vacuum cleaners. In addition, when the display module has a function of transmitting light, the display module may be applied to electronic devices, such as a smart window or a transparent display device that displays a background and a display image together. The types of electronic devices according to embodiments are not limited to those described above, and application of various other electronic devices not described herein may also be possible.

Therefore, the electronic device may provide a clear image.

The method and apparatus for manufacturing a display device, according to embodiments, are capable of precisely and firmly bonding the curved portion of the cover member to the display panel.

The method and apparatus for manufacturing a display device, according to embodiments, may provide uniform bonding quality on the entire surface of the cover member.

The method and apparatus for manufacturing a display device, according to embodiments, may maintain a uniform tension on the entire surface of the guide film during bonding.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. An apparatus (1000) for manufacturing a display device, the apparatus (1000) comprising:
a first jig (510) having a first working surface;
a clamping part (700) spaced apart from the first jig (510), and the clamping part (700) supporting a guide film (GF);
a second jig (610) having a second working surface disposed to have the second working surface face the first working surface of the first jig (510), wherein on the second jig (610) a cover member having a curved edge is seated; and
a sensing part (790) disposed on the clamping part (700), wherein the sensing part (790) is configured to measure a force applied to the guide film (GF) by the clamping part (700).

2. The apparatus (1000) of claim 1, wherein the clamping part (700) comprises:
a clamp (770) configured to selectively grip the guide film (GF);
a first clamp driving part (710) connected to the clamp (770) and configured to cause the clamp (770) to perform a linear motion;
a second clamp driving part (740) connected to the first clamp driving part (710) and configured to adjust a height of the clamp (770); and
a third clamp driving part (780) connected to the second clamp driving part (740) and configured to operate the clamp (770).

3. The apparatus (1000) of any one of claims 1 or 2, further comprising a guide (810) disposed to surround a periphery of the second jig (610) and selectively coming into contact with the guide film (GF).

4. The apparatus (1000) of claim 3, wherein a portion of the guide (810) that selectively comes into contact with the guide film (GF) is round.

5. The apparatus (1000) of any one of claims 3 or 4, wherein the guide (810) comprises:
a guide frame (812);
a first guide roller (813) rotatably disposed on the guide frame (812); and
a second guide roller (814) disposed in a longitudinal direction and a diagonal direction to the first guide roller (813) and rotatably disposed on the guide frame (812).

6. The apparatus (1000) of any one of claims 3 to 5, further comprising a guide driving part (820) configured to connect the guide (810) to the second jig (610) and cause the guide (810) to perform a raising and/or lowering motion.

7. The apparatus (1000) of any one of claims 3 to 6, further comprising a stopper part (910) spaced apart from the first jig (510) and selectively coming into contact with the guide (810).

8. The apparatus (1000) of any one of the preceding claims, further comprising a jig driving part (130) connected to at least one of the first jig (510) or the second jig (610) and configured to cause at least one of the first jig (510) or the second jig (610) to perform a linear motion.

9. The apparatus (1000) of any one of the preceding claims, further comprising a heating part disposed in at least one of the first jig (510) or the second jig (610).

10. The apparatus (1000) of any one of claims 3 to 9, wherein the first jig is capable of performing a linear motion;
wherein a panel member is disposed on the guide film (GF);
wherein the second jig (610) is capable of performing a linear motion to bond the cover member of the second jig (610) to the panel member together with the firstjig (510); and
wherein the guide (810) is configured to come into contact with the guide film (GF) before the cover member comes into contact with the panel member, so that a shape of the panel member is changed.

11. A method of manufacturing a display device, the method comprising:
disposing a cover member on a second jig (610), the cover member having an entire edge that is curved, and fixing a guide film (GF) to a clamping part (700), the guide film (GF) having a panel member and an adhesive layer disposed thereon;
bringing a guide (810) into contact with the guide film (GF) so that the guide film (GF), on which the panel member and the adhesive layer are disposed, is deformed to correspond to one surface of the cover member;
adjusting forces applied to at least two parts of the guide film (GF) to be equal to a preset force; and
bonding the cover member to the adhesive layer by causing at least one of a first jig (510) or the second jig (610) to perform a linear motion.

12. The method of claim 11, further comprising bringing the guide (810) into contact with a stopper part (910) and/or
further comprising bending a portion of the guide film (GF), a portion of the panel member, and a portion of the adhesive layer by causing the first jig (510) to perform a linear motion, and/or
further comprising measuring a force of pulling the guide film (GF) at each of the at least two parts of the guide film (GF).

13. The method of any one of claims 11 or 12, further comprising enclosing a space, in which the first jig (510) and the second jig (610) are disposed, with a first chamber (410) and a second chamber (420), and, optionally, further comprising discharging, to an outside, gas inside a space formed by the first chamber (410) and the second chamber (420).

14. The method of any one of claims 11 to 13, further comprising aligning a position of the panel member with respect to the cover member, and, optionally, wherein the first jig (510) moves together with the panel member.

15. The method of any one of claims 11 to 14, wherein a portion of the guide (810) that comes into contact with the guide film (GF) is round and/or further comprising heating at least one of the first jig (510) or the second jig (610).
